(19) Europäisches Patentamt
European Patent Office
Office européen des brevets

(11) EP 2 230 328 A1

(12) EUROPEAN PATENT APPLICATION
published in accordance with Art. 153(4) EPC

(43) Date of publication:
**22.09.2010 Bulletin 2010/38**

(21) Application number: **08866921.3**

(22) Date of filing: **19.12.2008**

(51) Int Cl.:
***C23C 18/20*** (2006.01) ***C23C 18/28*** (2006.01)

(86) International application number:
**PCT/JP2008/073158**

(87) International publication number:
**WO 2009/084470 (09.07.2009 Gazette 2009/28)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **27.12.2007 JP 2007338037**
**25.03.2008 JP 2008077811**

(71) Applicant: **FUJIFILM Corporation**
**Tokyo 106-8620 (JP)**

(72) Inventors:
- **NAGASAKI, Hideo**
**Ashigarakami-gun**
**Kanagawa 258-8577 (JP)**
- **SATO, Masataka**
**Ashigarakami-gun**
**Kanagawa 258-8577 (JP)**

(74) Representative: **HOFFMANN EITLE**
**Patent- und Rechtsanwälte**
**Arabellastrasse 4**
**81925 München (DE)**

# (54) PLATING METHOD, METHOD FOR FORMING METAL THIN FILM, AND PLATING CATALYST LIQUID

(57) A plating method comprising: (a) applying a plating catalyst liquid containing a catalytic element and an organic solvent, to an object to be plated having, at least at a surface thereof, a functional group capable of forming an interaction with the catalytic element; and (b) performing plating on the object to be plated, to which the plating catalyst liquid has been applied.



Printed by Jouve, 75001 PARIS (FR)

## Description

### TECHNICAL FIELD

The invention relates to a plating method, a method for forming a metal thin film using the plating method, and a plating catalyst liquid used in the plating method.

### BACKGROUND ART

It has been traditionally general, upon performing electroless plating on an object to be plated, to have a catalyst applied on the surface of the object to be plated as a plating base, by immersing the object to be plated into a water-based plating catalyst liquid. However, when the surface of the object to be plated is hydrophobic, the object to be plated repels the plating catalyst liquid so that there occur a problem that the catalyst cannot be applied. In this case, there was a problem that more steps are needed to treat the hydrophobic surface of the object to be plated to render the surface hydrophilic, or the like.
In order to perform electroless plating on a hydrophobic object to be plated, use can be made of, for example, a reduced metal colloid dispersion liquid which is obtainable by reducing a salt or a complex of a metal in a mixed solution containing a lower alcohol and an aprotic polar compound, such as described in Patent Document 1. This plating catalyst liquid is non-water-based, and makes it easy to apply catalyst to a hydrophobic object to be plated.
The method for plating a hydrophobic object to be plated using such a non-water-based plating catalyst liquid as described above is described in, for example, Patent Document 2, and specifically, there is disclosed a method for plating a hydrophobic object to be plated by using a non-water-based plating catalyst liquid and a non-water-based electroless plating liquid.
However, if non-water-based liquids are used for both the plating catalyst liquid and the electroless plating liquid as such, there is a problem that environmental burden is high in relation to the amount of use of organic solvent.
Furthermore, Cited Document 2 describes that in order to use a water-based plating catalyst liquid for a hydrophobic object to be plated, the object to be plated needs to be subjected to hydrophilization and roughening treatments in advance, and also drying is needed after the application of the plating catalyst (furthermore, not only the number of steps increases, but also the plating catalyst activity is decreased). Thus, it is understood that it is difficult to obtain a satisfactory plating film for a hydrophobic object to be plated, while reducing the environmental burden.

Patent Document 1: Japanese Patent Application Laid-Open (JP-A) No. 1-315334
Patent Document 2: JP-A No. 2001-181853

### DISCLOSURE OF THE INVENTION

### PROBLEM TO BE SOLVED BY THE INVENTION

Thus, the invention was made in consideration of the defects of the related art as described above, and it is an object of the invention to achieve the goals shown below.
That is, an object of the invention is to provide a plating method which is capable of reducing environmental burden at the time of plating a hydrophobic object to be plated and is capable of forming a plating film having excellent adhesiveness irrespective of whether the object to be plated is hydrophilic or hydrophobic, a method for forming a metal film using the plating method, and a plating catalyst liquid used in the plating method.

### MEANS FOR SOLVING PROBLEM

The inventors of the invention made a thorough investigation under such circumstances, and as a result, they found that the objects described above may be achieved by the technique shown below.
That is, the plating method of the invention is characterized by having the steps of (a) applying a plating catalyst liquid containing a catalytic element and an organic solvent, to an object to be plated which has, at least at a surface of the object to be plated, a functional group capable of forming an interaction with the catalytic element; and (b) plating the object to be plated to which the plating catalyst liquid has been applied.
In regard to the plating method of the invention, it is preferable that the object to be plated be an object having, on the surface of a base material, a polymer layer formed from a polymer which has a functional group capable of forming an interaction with the catalytic element and is directly chemically bonded to the surface of the base material.
It is also preferable that this polymer layer be a layer formed by directly chemically bonding the polymer having a polymerizable group capable of forming an interaction with the catalytic element and a functional group, to the surface

of the base material.
According to a more preferred aspect, the polymer having a polymerizable group capable of forming an interaction with the catalytic element and a functional group, is a copolymer containing a unit represented by the following formula (1) and a unit represented by the following formula (2).

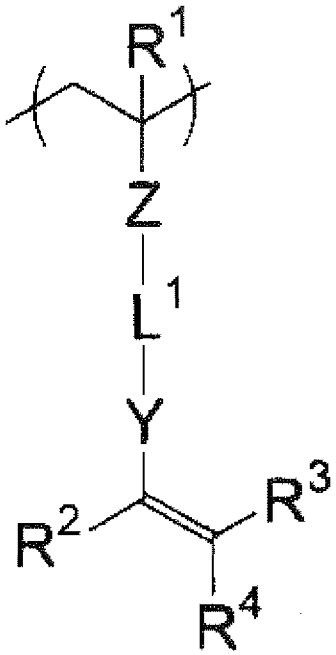

Formula (1)

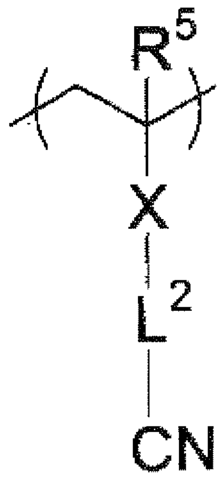

Formula (2)

In formula (1) and formula (2), $R^1$ to $R^5$ each independently represent a hydrogen atom, a substituted alkyl group, or an unsubstituted alkyl group; X, Y and Z each independently represent a single bond, a substituted divalent organic group, an unsubstituted divalent organic group, an ester group, an amide group or an ether group; and $L^1$ and $L^2$ each independently represent a substituted divalent organic group, or an unsubstituted divalent organic group.

In the step (b) according to the plating method of the invention, it is preferable to perform electroless plating, and it is more preferable to use a water-based electroless plating bath at the time of electroless plating.
Furthermore, in the plating method of the invention, the organic solvent constituting the plating catalyst liquid is preferably a ketone-based solvent, and particularly preferably acetone.
Furthermore, it is preferable that the plating catalyst liquid further contain water, and the content ratio of water and the organic solvent be 10:90 to 30:70 by mass.
It is also preferable that the catalytic element constituting the plating catalyst liquid be Pd.

The method for forming a metal thin film of the invention is **characterized in that** the method makes use of the plating method of the invention.
The plating catalyst liquid of the invention is **characterized in that** the plating catalyst liquid is used in the plating method of the invention and contains a catalytic element and an organic solvent.

EFFECT OF THE INVENTION

According to the invention, there may be provided a plating method which is capable of reducing environmental burden at the time of plating a hydrophobic object to be plated and is capable of forming a plating film having excellent adhesiveness irrespective of whether the object to be plated is hydrophilic or hydrophobic, a method for forming a metal film using the plating method, and a plating catalyst liquid used in the plating method.

BEST MODE FOR CARRYING OUT THE INVENTION

Hereinafter, the invention will be described in detail.

<Plating method and method for forming metal thin film>

The plating method of the invention is characterized by having the steps of (a) applying a plating catalyst liquid containing a catalytic element and an organic solvent, to an object to be plated which has, at least on the surface, a functional group capable of forming an interaction with the catalytic element; and (b) plating the object to be plated to which the plating catalyst liquid has been applied. Furthermore, the method for forming a metal tin film of the invention makes use of the plating method of the invention.
According to the invention, the object to be plated is able to have the catalytic element in the plating catalyst liquid effectively adsorbed to the object, irrespective of whether the object to be plated is hydrophilic or hydrophobic, because of the presence of a functional group capable of forming an interaction with the catalytic element. As a result, after the step (a), a sufficient amount of the catalytic element comes to attach to the surface of the object to be plated, and therefore, even when a water-based electroless plating bath is used in the following step (b), a satisfactory plating film may be obtained. As such, according to the plating method of the invention, a water-based bath may be used as the electroless plating bath, and an attempt may be made to reduce environmental burden at the time of plating a hydrophobic object to be plated.
Furthermore, since the functional group capable of forming an interaction with the catalytic element, which is present at the surface of the object to be plated, is forming an interaction (adsorption) with the catalytic element, a plating film having excellent adhesiveness to the object to be plated may be obtained by forming a plating film based on this catalytic element.
Hereafter, the steps (a) and (b) according to the plating method of the invention will be explained.

[Step (a)]

In the step (a) according to the invention, a plating catalyst liquid containing a catalytic element and an organic solvent is applied to an object to be plated having, at least at the surface, a functional group capable of forming an interaction with the catalytic element.

[Object to be plated]

First, the object to be plated that is used in the present step will be described.
The object to be plated according to the invention is not particularly limited in its shape, as long as the object has, at least at the surface, a functional group capable of forming an interaction with the catalytic element (hereinafter, appropriately referred to as "interactable group"), and has shape retainability to the extent that the object may be plated in the step (b) that will be described below. The shape of the object to be plated may be appropriately determined in accordance with the use of the plating film to be produced.
Furthermore, the effects of the invention may be obtained if the interactable group is present at least at the surface of the object to be plated, but the interactable group may also be present in the inside of the object to be plated, in addition to the surface. When the interactable group is present at the surface and inside the object to be plated, the catalytic element may adsorb to the interior in the thickness direction of the object to be plated, and thus it is preferable from the viewpoint of the adsorbability of the catalytic element.
The object to be plated according to the invention is preferably an object which has, at the surface of a base material, a functional group capable of forming an interaction with the catalytic element (interactable group) and has a polymer layer formed from a polymer that is directly chemically bonded to the base material. As the object has this polymer layer, an object to be plated having the interactable group present at the surface and in the inside may be obtained. Hereinafter, the polymer layer will be referred to as a "specific polymer layer," and the method for formation thereof will be described in detail.

(Surface graft)

If the object to be plated according to the invention is an object having a specific polymer layer on the surface of a base material as described above, it is preferable to use a general technique called surface graft polymerization. Graft polymerization is a method of synthesizing a graft (grafting) polymer by providing an active species on the chain of a macromolecular compound, and further polymerizing another monomer that initiates polymerization from this active species. In particular, when the macromolecular compound on which the active species is provided is formed on a solid

surface, the method is referred to as surface graft polymerization.

Any known methods described in the literature may all be used as the surface graft polymerization method applied in the invention. For example, a photo-graft polymerization method and a plasma irradiation graft polymerization method are described as surface graft polymerization methods in page 135 of New Polymer Experimentology 10, edited by the Society of Polymer Science, Japan, and published in 1994 by Kyoritsu Shuppan Co., Ltd. Furthermore, radiation irradiation graft polymerization methods using γ-rays, electron beams or the like are also described in pages 203 and 695 of Handbook of Adsorption Technology, published by NTS, Inc., under editorial supervision by Takeuchi in February 1999.

Specific methods of the photo-graft polymerization method that may be used include the methods described in JP-A No. 63-92658, JP-A No. 10-296895 and JP-A No. 11-119413.

According to the invention, a method also applicable as a method of obtaining an object to be plated having a specific polymer layer on the surface of the base material, in addition to the surface graft methods described above, may be a method of providing a reactive functional group such as a trialkoxysilyl group, an isocyanate group, an amino group, a hydroxyl group or a carboxyl group to a chain end of a macromolecular compound having a functional group capable of forming an interaction with the catalytic element, and binding this reactive functional group with a functional group that is present on the substrate surface by a coupling reaction.

Among these methods, it is preferable to use a photo-graft polymerization method, and more particularly, a photo-graft polymerization method making use of UV light, from the viewpoint of generating larger amounts of graft polymers on the surface of the base material.

(Base material)

The "base material" according to the invention is a material whose surface has a function of potentially forming a state in which a polymer having a functional group capable of forming an interaction with a catalytic element (interactable group) is directly chemically bonded to the surface. The base material itself may have such surface properties, or the base material may have an intermediate layer having such properties (for example, a polymerization initiating layer that will be described below).

The base material used in the invention is preferably a base material that is dimensionally stable, and examples thereof include paper, paper laminated with a plastic (for example, polyethylene, polypropylene, polystyrene, or the like), a metal plate (for example, aluminum, zinc, copper, or the like), a plastic film (for example, cellulose diacetate, cellulose triacetate, cellulose propionate, cellulose butyrate, cellulose acetate, cellulose nitrate, polyethylene terephthalate, polyethylene, polystyrene, polypropylene, polycarbonate, polyvinylacetal, polyimide, an epoxy, a bismaleinimide resin, polyphenylene oxide, a liquid crystal polymer, polytetrafluoroethylene, or the like), paper or a plastic film having a metal such as mentioned above laminated or deposited thereon, and the like are preferably used. For the base material used in the invention, an epoxy resin or a polyimide resin is preferred.

If the surfaces of these base materials have a function of potentially forming a state in which a polymer having an interactable group is directly chemically bonded to the surface, the polymerization initiating layer that will be described below and the like are not required.

As the base material according to the invention, the base material described in paragraphs [0028] to [0088] of JP-A No. 2005-281350, which contains a polyimide having a polymerization initiation site in the skeleton, may also be used.

The plating film obtained by the plating method of the invention may be applied to semiconductor packaging, various electric wiring boards, and the like. When the plating film is used for such purposes, it is preferable to use a base material containing an insulating resin that will be described below, more specifically, a base material formed from an insulating resin or a base material having a layer formed from an insulating resin.

When a base material formed from an insulating resin or a layer formed from an insulating resin is to be obtained, a known insulating resin composition is used. This insulating resin composition may contain various additives according to the purpose, in addition to a main resin. For example, measures may be taken, such as adding a polyfunctional acrylate monomer for the purpose of increasing the strength of the insulating layer, or adding inorganic or organic particles for the purpose of increasing the strength of the insulator layer and improving electrical properties.

Additionally, the "insulating layer" according to the invention means a resin having insulating properties to the extent that the resin can be used in a known insulating film or insulating layer. Thus, any resin that has insulating properties adequate for the purpose, even though it may not be a perfect insulator, may be applied in the invention.

Specifically, the insulating resin may be, for example, a thermosetting resin or a thermoplastic resin, or may be a mixture thereof. Examples include an epoxy resin, a phenolic resin, a polyimide resin, a polyester resin, a bismaleimide resin, a polyolefin-based resin, an isocyanate-based resin, a phenoxy resin, polyether sulfone, polysulfone, polyphenylene sulfone, polyphenylene sulfide, polyphenyl ether, polyether imide, a liquid crystal polymer, a fluororesin, a polyphenylene ether resin, a cyanate ester resin, a bis(bisphenylene)ethane resin, and the like, as described in paragraphs

[0014] to [0019] of JP-A No. 2007-144820, and modified resins thereof and the like may also be used.

The insulating resin composition may contain a component such as a compound having a polymerizable double bond, specifically, an acrylate or methacrylate compound, so as to carry out crosslinking, and particularly, a polyfunctional compound is preferred. In addition to those, a resin obtained by partially (meth)acrylating a thermosetting resin or a thermoplastic resin, for example, an epoxy resin, a phenol resin, a polyimide resin, a polyolefin resin, a fluororesin or the like, using methacrylic acid, acrylic acid or the like, may also be used as the compound having a polymerizable double bond.

The insulating resin composition according to the invention may also use a composite (composite material) of a resin and another component, so as to strengthen the properties of the resin film, such as mechanical strength, heat resistance, weather resistance, flame retardancy, water resistance and electrical properties. Examples of the material used in producing a composite include paper, glass fiber, silica particles, a phenolic resin, a polyimide resin, a bismaleimide triazine resin, a fluororesin, a polyphenylene oxide resin, and the like.

Furthermore, this insulating resin composition may also be incorporated, as necessary, with one or two or more kinds of fillers used in general resin materials for wiring substrates, for example, inorganic fillers such as silica, alumina, clay, talc, aluminum hydroxide and calcium carbonate, and organic fillers such as a cured epoxy resin, a crosslinked benzoguanamine resin and a crosslinked acrylic polymer. Among them, it is preferable to use silica as a filler material. This insulating resin composition may also be added, as necessary, with one or two or more kinds of various additives such as a colorant, a flame retardant, a tackifying agent, a silane coupling agent, an oxidation inhibitor, and an ultraviolet absorbent.

When these materials are added to the insulating resin composition, all of the materials are added preferably in an amount in the range of 1% by mass to 200% by mass, and more preferably in the range of 10% by mass to 80% by mass, based on the resin. If this amount of addition is less than 1% by mass, the effect of strengthening the above-mentioned properties is absent, and if the amount of addition is greater than 200% by mass, the properties inherent to the resin, such as strength, are deteriorated.

The base material used in the invention preferably has a surface unevenness of 500 nm or less, more preferably 100 nm or less, and even more preferably 50 nm or less, when the uses thereof in semiconductor packaging, various electrical wiring boards and the like are taken into consideration. As this surface unevenness of the base material (when an intermediate layer or a polymerization initiating layer is provided, the surface unevenness of that layer) is decreased, when the obtained metal pattern material is applied to wiring or the like, the electricity loss upon high frequency electric supply is reduced, which is preferable.

According to the invention, if the object to be plated (base material) is a plate-shaped object, for example, a resin film, the object may be allowed to have the interactable group present on both surfaces. As such, if a resin film has the interactable group present on both surfaces, the resin film will have plating films formed on both surfaces of the resin film, by further carrying out the step (b) that will be described below.

According to the invention, when the base material has a specific polymer layer on the surface, and the Specific polymer layer is formed by using a surface graft polymerization method, by which an active species is provided on the surface of the base material and a graft polymer is produced using the active species as a starting point, a base material containing a polymerization initiator (a compound capable of generating an active species) such as shown below or a base material having a polymerization initiating layer having a functional group capable of initiating polymerization, may be used upon the production of a graft polymer.

If this base material having a polymerization initiating layer formed thereon is a plate-shaped object, the polymerization initiating layer may be formed on both surfaces of the base material.

It is preferable that the polymerization initiating layer according to the invention be formed by using a resin composition having satisfactory adhesiveness to the base material, and it is more preferable that this resin composition contain a compound that generates an active species (polymerization initiator), which is used to form the specific polymer layer, or a compound having a site that is capable of generating an active species and a site that is capable of forming a chemical bonding with the substrate.

When the resin that constitutes the resin composition is a compound capable of generating an active species, it is not essentially necessary to add a compound that generates an active species, into the resin composition.

In regard to the polymerization initiating layer according to the invention, for example, when the base material is formed from a known insulating resin that has been used as a material for multilayer laminate boards, build-up boards or flexible boards, it is preferable to use an insulating resin composition also as the resin composition used upon forming the polymerization initiating layer, from the viewpoint of the adhesiveness to the substrate.

Now, an aspect in which the base material is formed from an insulating resin and the polymerization initiating layer is formed from an insulating resin composition, will be described below.

The insulating resin composition that is used for forming the polymerization initiating layer may contain the same electrically insulating resin as that constitutes the base material, or may contain a different resin, but it is preferable to use a resin that is close to the insulating resin that constitutes the base material, in terms of thermal properties such

as glass transition temperature, elastic modulus and coefficient of linear expansion. Specifically, it is preferable to use, for example, an insulating resin of the same type as the insulating resin that constitutes the base material, in view of adhesiveness.

The insulating resin according to the invention means a resin having insulating properties to the extent that the resin can be used in a known insulating film, and any resin that has insulating properties adequate for the purpose, even though it may not be a perfect insulator, may be applied in the invention.
Specifically, the insulating resin may be, for example, a thermosetting resin or a thermoplastic resin, or may be a mixture thereof. Examples of the thermosetting resin include an epoxy resin, a phenolic resin, a polyimide resin, a polyester resin, a bismaleimide resin, a polyolefin-based resin, an isocyanate-based resin and the like.

Examples of the thermoplastic resin include a phenoxy resin, polyether sulfone, polysulfone, polyphenylene sulfone, polyphenylene sulfide, polyphenyl ether, polyether imide, and the like.

The thermoplastic resin and the thermosetting resin may be respectively used singly, or may also be used in combination of two or more kinds. This is implemented for the purpose of exhibiting excellent effects by complementing the defects of the respective resins.

A resin having a skeleton that is capable of generating an active site on the occasion of forming a specific polymer layer, may also be used as the insulating resin used in the polymerization initiating layer. An example of this resin that may be used is a polyimide having a polymerization initiation site in the skeleton, as described in paragraphs [0018] to [0078] of JP-A No. 2005-307140.

Furthermore, the polymerization initiating layer may contain a compound having a polymerizable double bond, specifically, an acrylate or methacrylate compound, in order to allow crosslinking to proceed within the layer, and it is particularly preferable to use a polyfunctional compound. In addition to that, a resin obtained by partially (meth)acrylating a thermosetting resin or a thermoplastic resin such as, for example, an epoxy resin, a phenolic resin, a polyimide resin, a polyolefin resin or a fluororesin, using methacrylic acid, acrylic acid or the like, may also be used as the compound having a polymerizable double bond.

The polymerization initiating layer according to the invention may further have various compounds added therein according to the purpose, to the extent of not impairing the effects of the invention.
Specific examples of the additives include a material capable of relieving stress upon heating, such as rubber or SBR latex, a binder for improving film properties, a plasticizer, a surfactant, a viscosity adjusting agent, a curing agent, and the like. In regard to the curing agent, by adding the curing agent in an amount different from the stoichiometric amount of addition (amount of the curing agent required for all of the functional groups in the resin to react), the formation of through-holes or via-holes, and the desmear treatment after the formation may be facilitated at the time of forming a multilayer wiring board. Taking the case of an epoxy resin as an example, when an epoxy resin having an epoxy equivalent of 165 and a curing agent having an active hydrogen equivalent of 120 are used, the stoichiometric amount of addition of the curing agent is 73 phr. However, if the curing agent is added in an amount other than this amount of addition, the formation of through-holes or via-holes, and the desmear treatment after the formation may be facilitated.

The polymerization initiating layer according to the invention may also use a composite (composite material) of a resin and another component, so as to strengthen the properties of the resin film, such as mechanical strength, heat resistance, weather resistance, flame retardancy, water resistance and electrical properties. Examples of the material used in producing a composite include paper, glass fiber, silica particles, a phenolic resin, a polyimide resin, a bismaleimide triazine resin, a fluororesin, a polyphenylene oxide resin, and the like.

The polymerization initiating layer may also contain inorganic or organic particles as a component other than the insulating resin, in order to enhance the strength of the polymerization initiating layer and to improve electrical properties. Specific examples thereof include fillers used in general resin materials for wiring substrates, for example, inorganic fillers such as silica, alumina, clay, talc, aluminum hydroxide and calcium carbonate, and organic fillers such as a cured epoxy resin, a crosslinked benzoguanamine resin and a crosslinked acrylic polymer.

Furthermore, the polymerization initiating layer may also contain, if necessary, one or two or more kinds of various additives such as a colorant, a flame retardant, a tackifying agent, a silane coupling agent, an oxidation inhibitor and an ultraviolet absorbent.

When these materials are added, all of the materials are added preferably in an amount in the range of 0% by mass to 200% by mass, and more preferably in the range of 0% by mass to 80% by mass, based on the resin that constitutes a main component. When the base material adjacent to the polymerization initiating layer exhibits thermal or electrical property values that are equal or close to those of the polymerization initiating layer, it is not essentially necessary to add these additives. When the additives are used in an amount in the range of greater than 200% by mass based on the resin, there is a fear that the properties inherent to the resin itself, such as strength, may be decreased.

It is preferable that the polymerization initiating layer make use of a compound which is capable of generating an active species that is used for forming a specific polymer layer, as described above. In order to generate this active site, certain energy may be applied, and preferably, light (ultraviolet rays, visible rays, X-rays or the like), plasma (oxygen, nitrogen, carbon dioxide, argon or the like), heat, electricity or the like is used. Furthermore, an active site may also be

generated by chemically degrading the surface using an oxidative liquid (a solution of potassium permanganate) or the like.

Examples of the compound that is capable of generating an active species include, for example, the thermal polymerization initiators and photopolymerization initiators described in paragraphs [0043] and [0044] of JP-A No. 2007-154306. Here, the amount of the polymerization initiator contained in the polymerization initiating layer is preferably 0.1% by mass to 50% by mass, and more preferably 1.0% by mass to 30% by mass, based on the solids content.

The polymerization initiating layer according to the invention is formed by disposing a resin composition for forming a polymerization initiating layer on a base material by coating or the like, and eliminating the solvent.

The solvent used when this resin composition is prepared into a coating liquid, is not particularly limited if the solvent dissolves the components constituting the polymerization initiating layer. From the viewpoints of the ease of drying and workability, a solvent having a boiling point that is not excessively high is preferable, and specifically, a solvent having a boiling point of about 40°C to 150°C may be selected.

Specifically, cyclohexanone, methyl ethyl ketone and the like as described in paragraph [0045] of JP-A No. 2007-154306 may be used. The solvents may be used singly or as mixtures. The concentration of the solids in the coating solution is suitably 2% by mass to 50% by mass.

The amount of coating used in the case of forming a polymerization initiating layer on a base material, in terms of mass after drying, is preferably 0.1 $g/m^2$ to 20 $g/m^2$, more preferably 0.1 $g/m^2$ to 15 $g/m^2$, and even more preferably 0.1 $g/m^2$ to 2 $g/m^2$, from the viewpoints of exhibiting sufficient adhesiveness and preventing peeling of a film by maintaining the film properties.

According to the invention, the polymerization initiating layer is formed, as a film is formed by disposing a resin composition on a base material and eliminating the solvent, as described above; however, in this case, it is preferable to preliminarily cure the film by performing heating and/or photo-irradiation. Particularly, when the film is preliminarily cured by drying by heating and then performing photo-irradiation, curing is carried out in advance to an extent corresponding to the presence of the compound having a polymerizable double bond. Therefore, the situation in which after a resin layer is formed on the polymerization initiating layer, the whole polymerization initiating layer falls off, may be effectively prevented, which is preferable.

In regard to the heating temperature and time, those conditions under which the coating solvent can sufficiently dry up may be selected, but in view of production suitability, it is preferable to select a temperature of 100°C or lower, and a drying time of 30 minutes or less, and it is more preferable to select heating conditions in the range of a drying temperature of 40°C to 80°C and a drying time of 10 minutes or less.

Furthermore, the polymerization initiating layer may be further subjected to a curing treatment of applying any energy, in addition to the preliminary film curing as described above. Examples of the energy that is applied include light, heat, pressure, an electron beam and the like, but heat or light is general for the present exemplary embodiment, and in the case of heat, it is preferable to add heat at 100°C to 300°C for 5 minutes to 120 minutes. The conditions for curing by heating may vary with the type of the material of the base material, the type of the resin composition that constitutes the polymerization initiating layer, and the like, and also with the curing temperature of these materials. However, it is preferable to select a temperature in the range of 120°C to 220°C and a curing time in the range of 20 minutes to 120 minutes.

Such a curing treatment as described above may be carried out immediately after the formation of the polymerization initiating layer, and if a preliminary curing treatment which takes for about 5 to 10 minutes is to be carried out after the formation of the polymerization initiating layer, the curing treatment may be carried out after all of those other respective steps that follow the formation of the polymerization initiating layer have been completed.

The polymerization initiating layer may also be formed by applying a known layer-forming method such as a transfer method or a printing method, in addition to the above-described coating method.

In the case of applying a transfer method, it is also acceptable to produce a transfer laminate having a bilayer construction of a layer obtained from the coating liquid for resin layer formation and a polymerization initiating layer, and to transfer the laminate onto the surface of a base material all at once according to a lamination method.

The thickness of the polymerization initiating layer according to the invention is generally in the range of 0.1 μm to 10 μm, and preferably in the range of 0.2 μm to 5 μm. In the case of providing a polymerization initiating layer, if the thickness falls in the range that is defined to be general, a sufficient strength for adhesion to the adjacent base material or specific polymer layer may be obtained. Furthermore, while the layer is thinner as compared with the case of using a common adhesive, an adhesion equal to that of a layer formed from the adhesive may be achieved. As a result, a metal plating film having a small overall thickness and excellent adhesiveness may be obtained.

The surface of the polymerization initiating layer according to the invention is such that the arithmetic average surface roughness Ra as defined in JIS B0633 (2001) is preferably 1 μm or less, and Ra is more preferably 0.5 μm or less, from the viewpoint of enhancing the properties of the formed metal plating film, or from the viewpoint of obtaining a printed wiring board having a fine-line circuit from the formed metal plating film. When the surface smoothness of the polymerization initiating layer falls in the range of the above-mentioned values, that is, the surface is in a state of being

highly smooth, the metal-clad base material is suitably used for the production of a printed wiring board having a very fine circuit (for example, a circuit pattern having a line/space value of 25/25 μm or less).

After the formation of the polymerization initiating layer, the surface may be roughened by a dry method and/or a wet method, for the purpose of enhancing the adhesiveness to the specific polymer formed on the surface. Examples of the dry roughening method include mechanical polishing such as buffing and sand blasting, and plasma etching. On the other hand, examples of the wet roughening method include chemical treatments, such as a method of using an oxidizing agent such as permanganate, bichromate, ozone, hydrogen peroxide/sulfuric acid or nitric acid, and a method of using a strong base or a resin swelling solvent.

(Binding of polymer)

Methods that may be used as the method for binding a polymer having an interactable group to a base material in the step (a), include a method of using a coupling reaction between the functional group present at the surface of the base material and the reactive functional group carried by the macromolecular compound having an interactable group, at its terminus or in a side chain, and a photo-graft polymerization method, as described above.

According to the invention, it is preferable to utilize an aspect in which a base material is contacted on the top with a compound having a functional group capable of forming interaction with a catalytic element (interactable group) and a polymerizable group, and then energy is applied thereto, so that the compound is directly chemically bonded to the surface of the base material (if a polymerization initiating layer is present, to the surface of the layer) through polymerization. That is, when an active species is generated at the surface of the base material by energy application, a polymerization reaction of the compound having an interactable group and a polymerizable group proceeds from the active species as a starting point. As a result, a form in which a polymer having an interactable group (graft polymer) is directly chemically bonded to the surface of the base material may be obtained.

The contact may be carried out by immersing the base material into a liquid composition containing the compound having an interactable group and a polymerizable group. However, from the viewpoint of handlability or production efficiency, it is preferable to form a layer formed from a composition containing the compound having an interactable group and a polymerizable group, on the surface of the base material (surface of the polymerization initiating layer) by a coating method, as will be described below.

Also in the case where the base material has a shape such as a resin film and polymer layers are formed on both surfaces of the base material, it is preferable to use a coating method, from the viewpoint that it is easy to simultaneously form resin layers on both surfaces.

The compound having an interactable group and a polymerizable group, which is used when a graft polymer is produced at the surface of the base material by a surface graft polymerization method according to the invention, will be explained.

The polymerizable group in the compound having an interactable group and a polymerizable group according to the invention is a functional group through which the compound having an interactable group and a polymerizable group reacts intermolecularly, or the compound having an interactable group and a polymerizable group binds to the base material, when energy is applied. Specific examples of the polymerizable group include a vinyl group, a vinyloxy group, an allyl group, an acryloyl group, a methacryloyl group, an oxetane group, an epoxy group, an isocyanate group, a functional group containing active hydrogen, the active group in an azo compound, and the like.

Examples of the interactable group according to the invention include a polar group (hydrophilic group), a group capable of forming polydentate coordination, and non-dissociable functional groups (functional groups that do not produce proton by dissociation) such as a nitrogen-containing functional group, a sulfur-containing functional group and an oxygen-containing functional group. Particularly, in order to reduce water absorbability and moisture absorbability of the plating film formed by the plating method of the invention, it is preferable to use a non-dissociable functional group as a site representing metal ion adsorption capacity.

The polar group may be a functional group having a positive charge, such as ammonium or phosphonium; or an acidic group which has a negative charge or can be dissociated into a negative charge, such as a sulfonic acid group, a carboxyl group, a phosphoric acid group or a phosphonic acid group. These adsorb to metal ions in the form of a counterion of the dissociating group.

Furthermore, for example, a nonionic polar group such as a hydroxyl group, an amide group, a sulfonamide group, an alkoxy group or a cyano group may also be used.

In addition to that, an amino group, a primary or secondary amino group, an amide group, a urethane group, a hydroxyl group (including phenol), a thiol group or the like may also be used.

Specifically, a group capable of coordinating with a metal ion, a nitrogen-containing functional group, a sulfur-containing functional group, an oxygen-containing functional group and the like are preferable as the non-dissociable functional group, and specific examples include nitrogen-containing functional groups such as an imide group, a pyridine group, a tertiary amino group, an ammonium group, a pyrrolidone group, an amidino group, a group containing a triazine

cyclic structure, a group containing an isocyanuric structure, a nitro group, a nitroso group, an azo group, a diazo group, an azide group, a cyano group and a cyanate group (R-O-CN); oxygen-containing functional groups such as an ether group, a carbonyl group, an ester group, a group containing an N-oxide structure, a group containing an S-oxide structure and a group containing an N-hydroxyl structure; sulfur-containing functional groups such as a thioether group, a thioxy group, a sulfoxide group, a sulfone group, a sulfite group, a group containing a sulfoximine structure, a group containing a sulfoxinium salt structure, and a group containing a sulfonic acid ester structure; phosphorus-containing functional groups such as a phosphine group; groups containing halogen atoms such as chlorine and bromine; an unsaturated ethylene group; and the like. Furthermore, in an aspect of representing non-dissociation properties due to the relationship with the adjacent atom or atomic group, an imidazole group, a urea group or a thiourea group may be used.
Among them, an ether group (more specifically, a structure represented by $-O-(CH_2)_n-O-$ (wherein n is an integer from 1 to 5)) or a cyano group is particularly preferable, and a cyano group is most preferable, from the viewpoint of exhibiting high polarity and high adsorption capacity to a plating catalyst or the like.

In general, there is a tendency that an increase in polarity leads to an increase in the water absorption ratio. However, since cyano groups interact with each other so as to cancel the polarity of each other in the polymer layer, the film becomes dense, while water absorbability is lowered because the overall polarity of the polymer layer is decreased. Also, when a catalyst is adsorbed using a good solvent of the polymer layer, the cyano group is solvated, and thus the interaction between cyano groups disappears, thereby making the cyano group capable of interacting with the plating catalyst. As discussed above, a polymer layer having a cyano group is preferred from the viewpoint of exhibiting contradictory performances, such as being less moisture absorptive while highly interacting with the plating catalyst.
Furthermore, the interactable group according to the invention is more preferably an alkylcyano group. This is preferred from the viewpoint of adsorbability to plating catalyst or the like, because while an aromatic cyano group has electrons withdrawn to the aromatic ring and has a lower donating property for unpaired electrons, which are important in terms of the adsorbability to plating catalyst or the like, an alkylcyano group does not have this aromatic ring bound thereto.

According to the invention, the compound having an interactable group and a polymerizable group may be in any form of a monomer, a macromonomer or a polymer, and among them, it is preferable to use a polymer (a polymer having an interactable group and a polymerizable group) from the viewpoint of the properties for the formation of polymer layer and the ease of control.
The polymer having an interactable group and a polymerizable group is preferably a polymer obtained by introducing an ethylene addition polymerizable unsaturated group (polymerizable group) such as a vinyl group, an allyl group or a (meth)acryl group, as a polymerizable group, to a homopolymer or a copolymer obtainable by using a monomer having an interactable group. This polymer having an interactable group and a polymerizable group is a polymer having a polymerizable group at least at the end of the main chain or a side chain, and a polymer having a polymerizable group in a side chain is preferred.
The compound having an interactable group and a polymerizable group, which has a non-dissociable functional group as the interactable group, will be described below in detail.

In regard to the monomer having an interactable group that is used to obtain the polymer having an interactable group and a polymerizable group, any monomer that has the non-dissociable functional group described above may be put to use, but specific examples thereof include the following.
These may be used singly, or may be used in combination of two or more kinds.

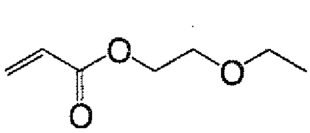
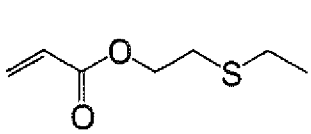
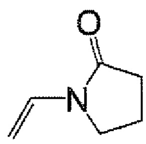

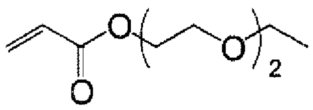
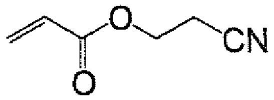
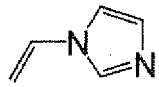

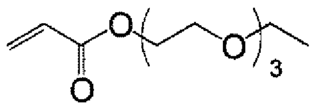
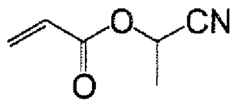
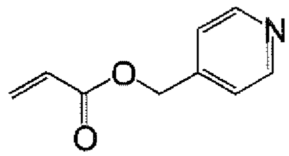

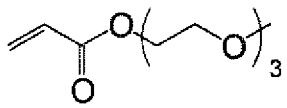
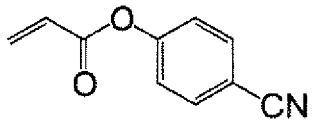
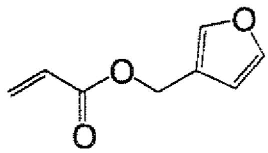

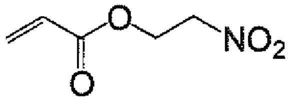
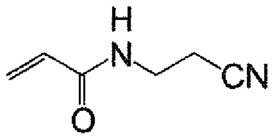
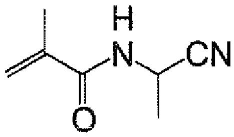

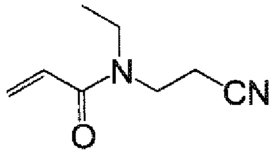

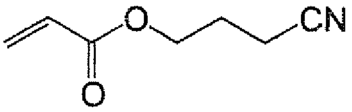

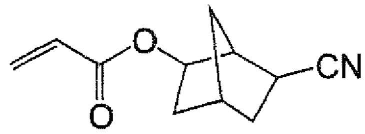

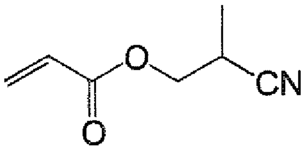

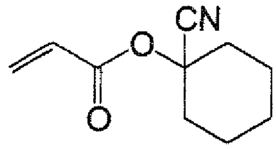

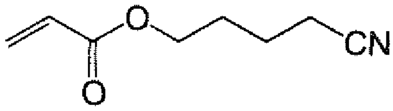

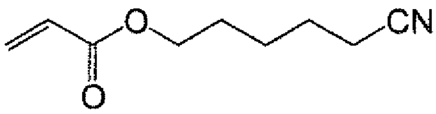

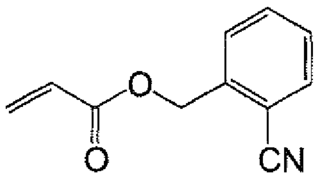

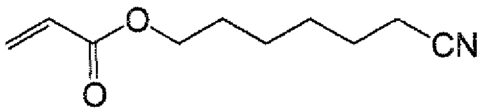

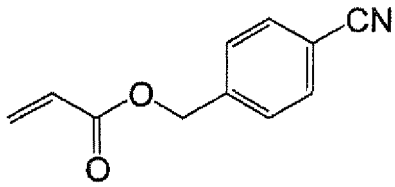

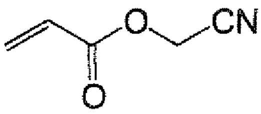

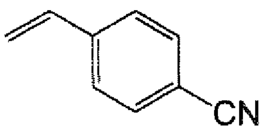

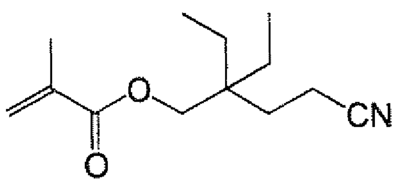

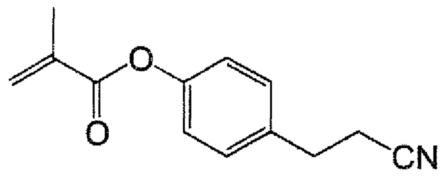

In regard to the polymer having an interactable group and a polymerizable group, the unit derived from a monomer having an interactable group is preferably contained in a content in the range of 50% by more to 95% by mole, and more preferably contained in a content in the range of 40 to 80% by mole, in the polymer having an interactable group and a polymerizable group, from the viewpoint of the properties for the formation of interaction with the plating catalyst or a precursor thereof.

Upon obtaining a polymer having an interactable group and a polymerizable group, other monomers may also be used in addition to the monomer having an interactable group, so as to lower water absorbability and to enhance hydrophobicity. General polymerizable monomers may be used as the other monomers, and examples include diene-based monomers, acrylic monomers and the like. Among them, an acrylic monomer of unsubstituted alkyl is preferred. Specifically, tertiary-butyl acrylate, 2-ethylhexyl acrylate, butyl acrylate, cyclohexyl acrylate, benzyl methacrylate, and the like may be preferably used.

Such a polymer having an interactable group and a polymerizable group may be synthesized as follows.

Examples of the synthesis method include i) a method of copolymerizing a monomer having an interactable group and a monomer having a polymerizable group; ii) a method of copolymerizing a monomer having an interactable group and a monomer having a double bond precursor, and then introducing a double bond by treating the product with a base or the like; and iii) a method of reacting a polymer having an interactable group with a monomer having a polymerizable group, and thereby introducing a double bond (introducing a polymerizable group). Preferred methods from the viewpoint of synthesis suitability are ii) a method of copolymerizing a monomer having an interactable group and a monomer having a double bond precursor, and then introducing a double bond by treating the product with a base or the like, and iii)) a method of reacting a polymer having an interactable group with a monomer having a polymerizable group, and thereby introducing a polymerizable group.

Monomers similar to the monomers having an interactable group as described above may be used as the monomer having an interactable group, which is used in the synthesis of the polymer having an interactable group and a polymerizable group. The monomers may be used singly, or may be used in combination of two or more kinds.

Examples of the monomer having a polymerizable group, which is copolymerized with a monomer having an interactable group, include allyl (meth)acrylate, 2-allyloxyethyl methacrylate, and the like.

Examples of the monomer having a double bond precursor include 2-(3-chloro-1-oxopropoxy)ethyl methacrylate, 2-(3-bromo-1-oxopropoxy)ethyl methacrylate, and the like.

Furthermore, examples of the monomer having a polymerizable group, which is used to introduce an unsaturated group by using a reaction with a functional group in a polymer having an interactable group, such as a carboxyl group, an amino group or a salt thereof, a hydroxyl group or an epoxy group, include (meth)acrylic acid, glycidyl (meth)acrylate, allyl glycidyl ether, 2-isocyanatoethyl (meth)acrylate, and the like.

Specific examples of the polymer having an interactable group and a polymerizable group, which may be suitably used in the invention, will be presented below, but the invention is not intended to be limited to these.

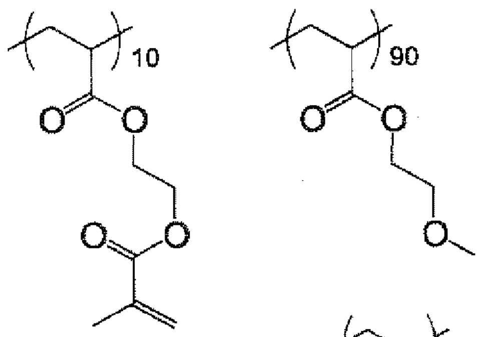

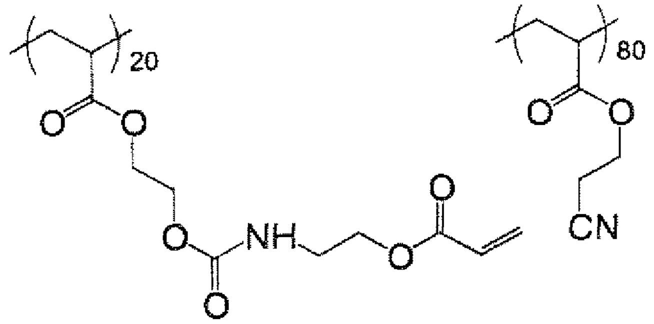

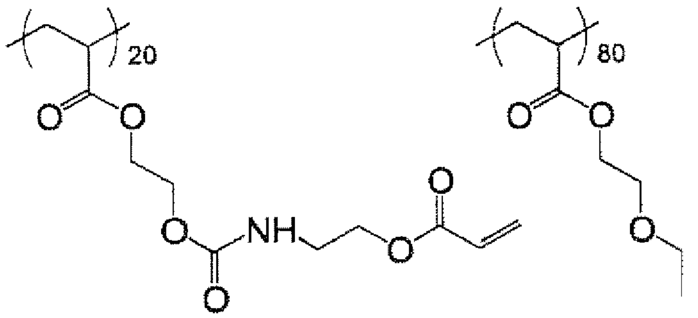

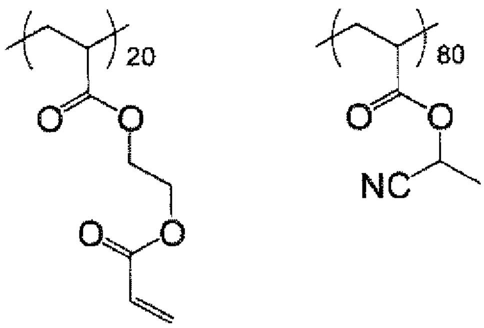

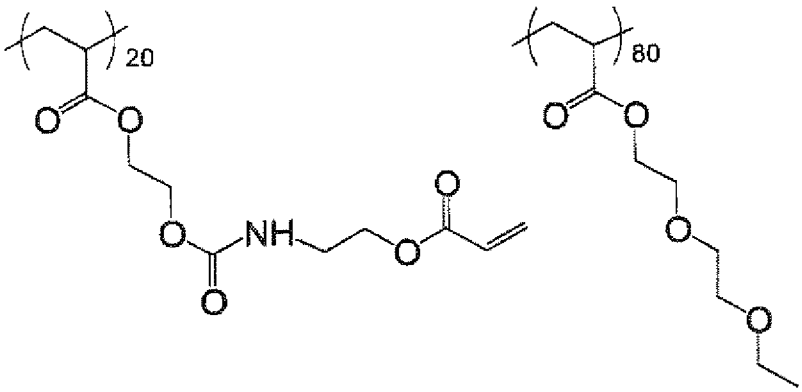

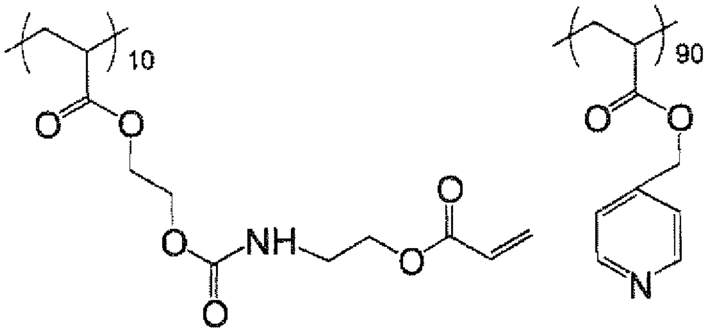

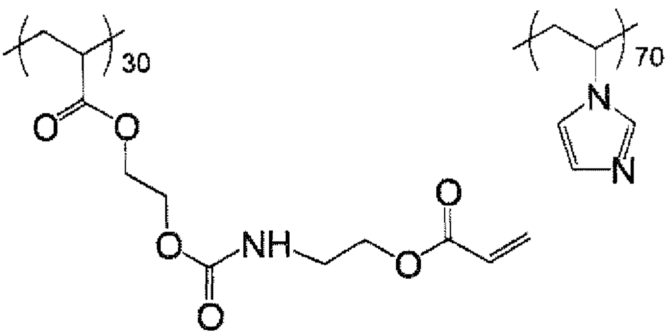

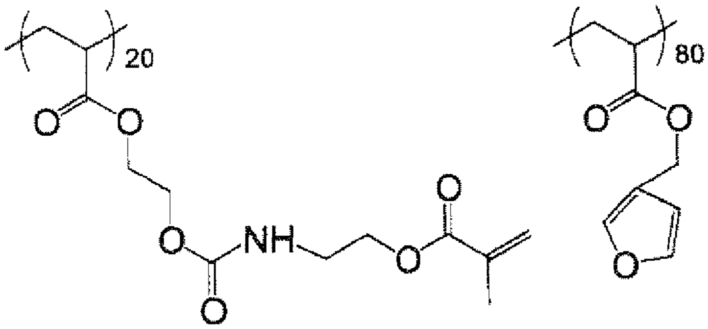

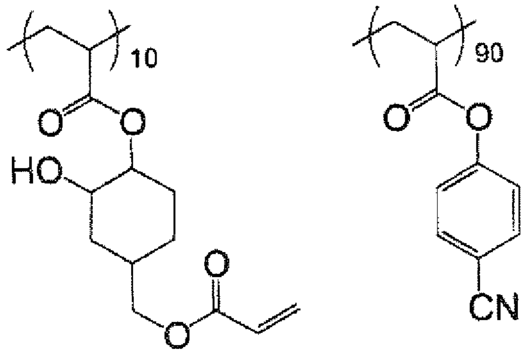

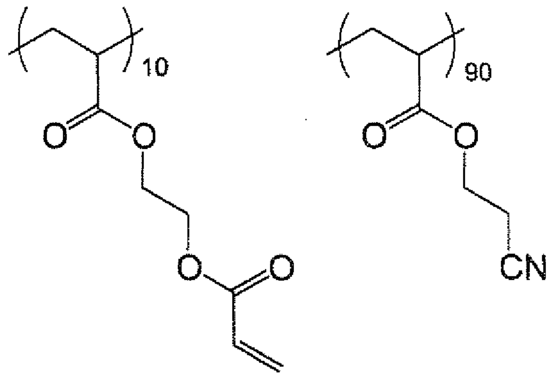

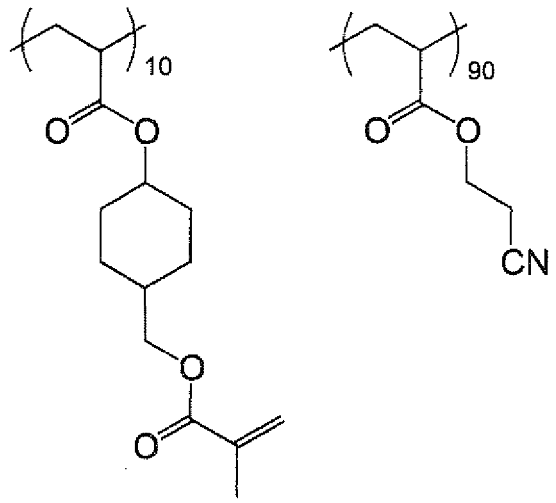

Next, a polymer having a cyano group and a polymerizable group (hereinafter, will be appropriately referred to as "cyano group-containing polymerizable polymer"), which is the most preferable as the polymer having an interactable group and a polymerizable group according to the invention, will be explained.

The cyano group-containing polymerizable polymer according to the invention is preferably, for example, a copolymer which contains a unit represented by the following formula (1) and a unit represented by the following formula (2).

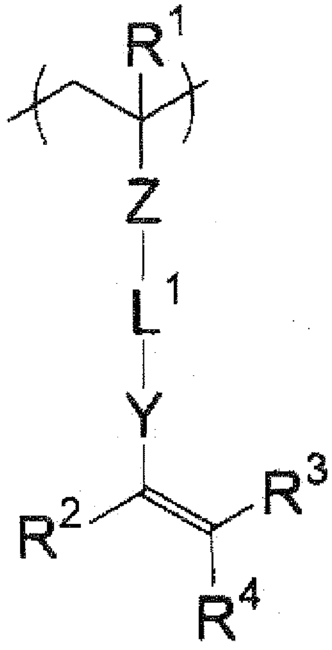

Formula (1)

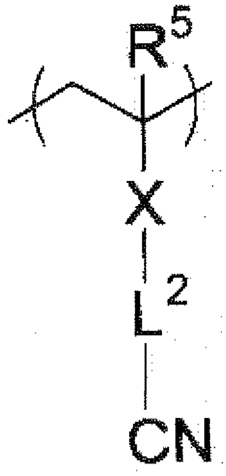

Formula (2)

In formula (1) and formula (2), $R^1$ to $R^5$ each independently represent a hydrogen atom, a substituted alkyl group, or an unsubstituted alkyl group; X, Y and Z each independently represent a single bond, a substituted divalent organic group, an unsubstituted divalent organic group, an ester group, an amide group or an ether group; and $L^1$ and $L^2$ each independently represent a substituted divalent organic group or an unsubstituted divalent organic group.

When $R^1$ to $R^5$ each represent a substituted or unsubstituted alkyl group, examples of the unsubstituted alkyl group include a methyl group, an ethyl group, a propyl group and a butyl group, and examples of the substituted alkyl group include a methyl group, an ethyl group, a propyl group and a butyl group, each substituted with a methoxy group, a hydroxyl group, a chlorine atom, a bromine atom, a fluorine atom or the like.

$R^1$ is preferably a hydrogen atom, a methyl group, or a methyl group substituted with a hydroxyl group or a bromine atom.

$R^2$ is preferably a hydrogen atom, a methyl group, or a methyl group substituted with a hydroxyl group or a bromine atom.

$R^3$ is preferably a hydrogen atom.

$R^4$ is preferably a hydrogen atom.

$R^5$ is preferably a hydrogen atom, a methyl group, or a methyl group substituted with a hydroxyl group or a bromine atom.

When X, Y and Z each represent a substituted or unsubstituted divalent organic group, examples of the divalent organic group include a substituted or unsubstituted aliphatic hydrocarbon group, and a substituted or unsubstituted aromatic hydrocarbon group.

The substituted or unsubstituted aliphatic hydrocarbon group is preferably a methylene group, an ethylene group, a propylene group, a butylene group, or each of these groups substituted with a methoxy group, a hydroxyl group, a chlorine atom, a bromine atom, a fluorine atom or the like.

The substituted or unsubstituted aromatic hydrocarbon group is preferably an unsubstituted phenyl group, or a phenyl group substituted with a methoxy group, a hydroxyl group, a chlorine atom, a bromine atom, a fluorine atom or the like.

Among them, $-(CH_2)_n-$ (n is an integer from 1 to 3) is preferred, and $-CH_2-$ is more preferred.

$L^1$ is preferably a divalent organic group having a urethane bond or a urea bond, and more preferably a divalent organic group having a urethane bond. Among them, such a group having a total carbon number of 1 to 9 is preferred. Here, the total carbon number of $L^1$ means the total number of carbon atoms contained in the substituted or unsubstituted divalent organic group represented by $L^1$.

More specifically, the structure of $L^1$ is preferably a structure represented by the following formula (1-1) or formula (1-2).
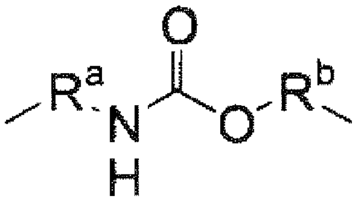

Formula (1-1)

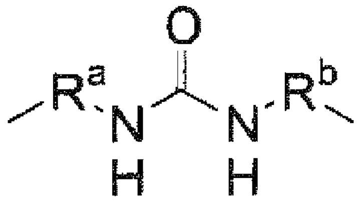

Formula (1-2)

In formula (1-1) and formula (1-2), $R^a$ and $R^b$ each independently represent a divalent organic group formed by using two or more atoms selected from the group of a carbon atom, a hydrogen atom and an oxygen atom, and preferred examples thereof include a methylene group, an ethylene group, a propylene group and a butylene group, each being substituted or unsubstituted, as well as an ethylene oxide group, a diethylene oxide group, a triethylene oxide group, a tetraethylene oxide group, a dipropylene oxide group, a tripropylene oxide group, and a tetrapropylene oxide group.
$L^2$ is preferably a straight-chained, branched or cyclic alkylene group, an aromatic group, or a group obtained by combining these. The group obtained by combining an alkylene group and an aromatic group may be further interrupted by an ether group, an ester group, an amide group, a urethane group or a urea group. Among them, $L^2$ is preferably such a group having a total carbon number of 1 to 15, and particularly preferably an unsubstituted group. Here, the total carbon number of $L^2$ means the total number of carbon atoms contained in the substituted or unsubstituted divalent organic group represented by $L^2$.
Specific examples thereof include a methylene group, an ethylene group, a propylene group, a butylene group, a phenylene group, and these groups substituted with a methoxy group, a hydroxyl group, a chlorine atom, a bromine atom, a fluorine atom or the like, and also include groups obtained by combining these.
For the cyano group-containing polymerizable polymer according to the invention, the unit represented by the formula (1) is preferably a unit represented by the following formula (3).
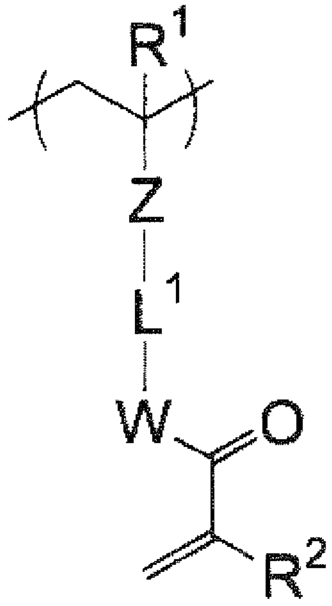

Formula (3)

In formula (3), $R^1$ and $R^2$ each independently represent a hydrogen atom, or a substituted or unsubstituted alkyl group; Z represents a single bond, a substituted or unsubstituted divalent organic group, an ester group, an amide group or an ether group; W represents an oxygen atom, or NR (wherein R represents a hydrogen atom or an alkyl group, and is preferably a hydrogen atom, or an unsubstituted alkyl group having 1 to 5 carbon atoms); and $L^1$ represents a substituted or unsubstituted divalent organic group.

$R^1$ and $R^2$ in the formula (3) have the same definitions as defined for $R^1$ and $R^2$ in the formula (1), respectively, and also have the same preferable definitions as defined for $R^1$ and $R^2$ in the formula (1), respectively.

Z in the formula (3) has the same definition as defined for Z in the formula (1), and also has the same preferable definition as defined for Z in the formula (1).

Furthermore, $L^1$ in the formula (3) has the same definition as defined for $L^1$ in the formula (1), and also has the same preferable definition as defined for $L^1$ in the formula (1).

For the cyano group-containing polymerizable polymer according to the invention, the unit represented by the formula (3) is preferably a unit represented by the following formula (4).

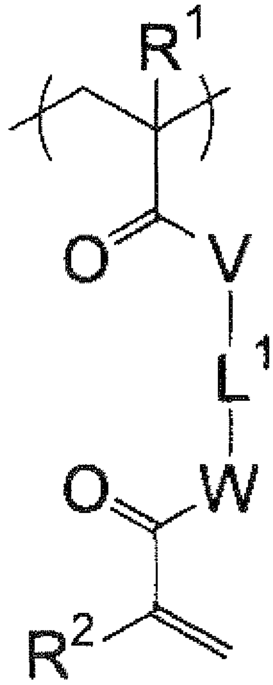

Formula (4)

In formula (4), $R^1$ and $R^2$ each independently represent a hydrogen atom, or a substituted or unsubstituted alkyl group; V and W each independently represent an oxygen atom, or NR (wherein R represents a hydrogen atom or an alkyl group, and is preferably a hydrogen atom or an unsubstituted alkyl group having 1 to 5 carbon atoms); and $L^1$ represents a substituted or unsubstituted divalent organic group.

$R^1$ and $R^2$ in the formula (4) have the same definitions as defined for $R^1$ and $R^2$ in the formula (1), respectively, and also have the same preferable definitions as defined for $R^1$ and $R^2$ in the formula (1), respectively.

$L^1$ in the formula (4) has the same definition as defined for $L^1$ in the formula (1), and also has the same preferable definition as defined for $L^1$ in the formula (1).

In formula (3) and formula (4). W is preferably an oxygen atom.

In formula (3) and formula (4), $L^1$ is preferably an unsubstituted alkylene group, or a divalent organic group having a urethane bond or a urea bond, and more preferably a divalent organic group having a urethane bond. Among these, such a group having a total carbon number of 1 to 9 is particularly preferred.

For the cyano group-containing polymerizable polymer according to the invention, the unit represented by the formula (2) is preferably a unit represented by the following formula (5).

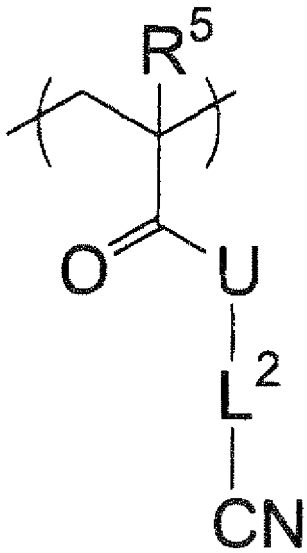

Formula (5)

In formula (5), $R^5$ represents a hydrogen atom, or a substituted or unsubstituted alkyl group; U represents an oxygen atom, or NR' (wherein R' represents a hydrogen atom or an alkyl group, and is preferably a hydrogen atom or an unsubstituted alkyl group having 1 to 5 carbon atoms); and $L^2$ represents a substituted or unsubstituted divalent organic group.
$R^5$ in the formula (5) has the same definition as defined for $R^1$ and $R^2$ in the formula (1), and is preferably a hydrogen atom.
$L^2$ in the formula (5) has the same definition as defined for $L^2$ in the formula (2), and is preferably a straight-chained, branched or cyclic alkylene group, an aromatic group, or a group obtained by combining these.
Particularly, in formula (5), the linking site to the cyano group in $L^2$ is preferably a divalent organic group having a straight-chained, branched or cyclic alkylene group, and among others, this divalent organic group is preferably such a group having a total carbon number of 1 to 10.
In another preferred aspect, the linking site to the cyano group in $L^2$ in formula (5) is preferably a divalent organic group having an aromatic group, and among others, this divalent organic group is preferably such a group having a total carbon number of 6 to 15.
The cyano group-containing polymerizable polymer according to the invention is a polymer which is constituted to contain units represented by the formula (1) to (5) and has a polymerizable group and a cyano group in side chains. This cyano group-containing polymerizable polymer may be synthesized, for example, as will be described below.
The type of the polymerization reaction used upon synthesizing the cyano group-containing polymerizable polymer according to the invention, may be radical polymerization, cationic polymerization or anionic polymerization. From the viewpoint of reaction control, it is preferable to use radical polymerization or cationic polymerization.
The synthesis method for the cyano group-containing polymerizable polymer according to the invention may be different between: 1) the case where the polymerization mode for forming the polymer main chain is different from the polymerization mode for the polymerizable group to be introduced into a side chain; and 2) the case where the polymerization mode for forming the polymer main chain is identical with the polymerization mode for the polymerizable group to be introduced into a side chain.

1) Case where the polymerization mode for forming the polymer main chain is different from the polymerization mode for the polymerizable group to be introduced into a side chain

Examples of the case where the polymerization mode for forming the polymer main chain is different from the polymerization mode for the polymerizable group to be introduced into a side chain, include: 1-1) an aspect in which the formation of the polymer main chain is carried out by cationic polymerization, and the polymerization mode for the

polymerizable group to be introduced into a side chain is radical polymerization; and 1-2) an aspect in which the formation of the polymer main chain is carried out by radical polymerization, and the polymerization mode for the polymerizable group to be introduced into a side chain is cationic polymerization.

1-1) Aspect in which the formation of the polymer main chain is carried out by cationic polymerization and the polymerization mode for the polymerizable group to be introduced into a side chain is radical polymerization

According to the invention, the monomers used in the aspect in which the formation of the polymer main chain is carried out by cationic polymerization and the polymerization mode for the polymerizable group to be introduced into a side chain is radical polymerization, include the following compounds.

• Monomers used for forming polymerizable group-containing unit

Examples of the monomers used for forming the polymerizable group-containing unit that is used in this aspect include vinyl (meth)acrylate, allyl (meth)acrylate, 4-(meth)acryloylbutane vinyl ether, 2-(meth)acryloylethane vinyl ether, 3-(meth)acryloylpropane vinyl ether, (meth)acryloyloxydiethylene glycol vinyl ether, (meth)acryloyloxytriethylene glycol vinyl ether, (meth)acryloyl $1^{st}$ terpionel, 1-(meth)acryloyloxy-2-metbyl-2-propene, 1-(meth)acryloylaxy-3-methyl-3-butene, 3-methylene-2-(meth)acryloyloxynorbomane, 4,4'-ethylidene diphenol di(meth)acrylate, methacrolein di(meth) acryloylacetal, p-((meth)acryloylmethyl)styrene, allyl (meth)acrylate, vinyl 2-(bromomethyl)acrylate, allyl 2-(hydroxymethyl)acrylate, and the like.

• Monomers used for forming cyano group-containing unit

Examples of the monomers used for forming the cyano group-containing unit that is used in this aspect include 2-cyanoethyl vinyl ether, cyanomethyl vinyl ether, 3-cyanopropyl vinyl ether, 4-cyanobutyl vinyl ether, 1-(p-cyanophenoxy)-2-vinyloxyethane, 1-(o-cyanophenoxy)-2-vinyloxyethane, 1-(m-eyanophenoxy)-2-vinyloxyethane, 1-(p-cyanophenoxy)-3-vinyloxypropane, 1-(p-cyanophenoxy)-4-vinyloxybutane, o-cyanobenzyl vinyl ether, m-cyanobenzyl vinyl ether, p-cyanobenzyl vinyl ether, allyl cyanide, allyl cyanoacetate, and the following compounds.

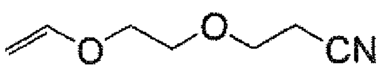 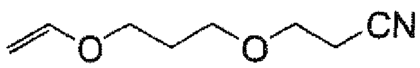

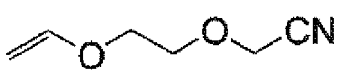 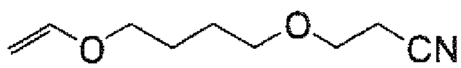

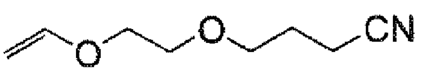 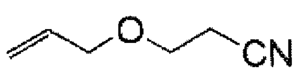

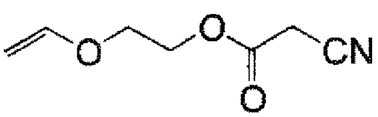 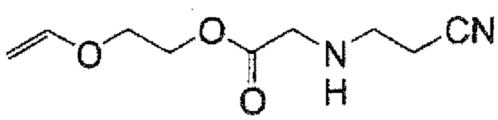

Polymerization may be carried out using the method described in Lectures on Experimental Chemistry "Polymer Chemistry," Chapter 2-4 (p. 74), or the general cationic polymerization method described in "Experimental Methods for

Polymer Synthesis," written by Otsu Takayuki, Chapter 7 (p. 195). In the cationic polymerization, a protic acid, a halogenated metal, an organometallic compound, an organic salt, a metal oxide, a solid acid or halogen may be used as an initiator, and among these, it is preferable to use a halogenated metal or an organometallic compound as an initiator which has high activity and is capable of synthesizing a high molecular weight compound.
Specific examples include boron trifluoride, boron trichloride, aluminum chloride, aluminum bromide, titanium tetrachloride, tin tetrachloride, tin bromide, phosphorus pentafluoride, antimony chloride, molybdenum chloride, tungsten chloride, iron chloride, dichloroethylaluminum, chlorodiethylaluminum, dichloromethylaluminum, chlorodimethylaluminum, trimethylaluminum, trimethylzinc, and methyl Grignard.

1-2) Aspect in which the formation of the polymer main chain is carried out by radical polymerization, and the polymerization mode for the polymerizable group to be introduced into a side chain is cationic polymerization

According to the invention, the monomers used in the aspect in which the formation of the polymer main chain is carried out by radical polymerization and the polymerization mode for the polymerizable group to be introduced into a side chain is cationic polymerization, include the following compounds.

• Monomers used for forming polymerizable group-containing unit

The same monomers as those used for forming a polymerizable group-containing unit, as mentioned in the aspect of (1-1), may be used.

• Monomers used for forming cyano group-containing unit

Examples of the monomers used for forming the cyano group-containing unit that is used in this aspect, include cyanomethyl (meth)acrylate, 2-cyanoethyl (meth)acrylate, 3-cyanopropyl (meth)acrylate, 2-cyanopropyl (meth)acrylate, 1-cyanoethyl (meth)acrylate, 4-cyanobutyl (meth)acrylate, 5-cyanopentyl (meth)acrylate, 6-cyanohexyl (meth)acrylate, 7-cyanohexyl (meth)acrylate, 8-cyanohexyl (meth)acrylate, 2-cyanoethyl (3-(bromomethyl)acrylate), 2-cyanoethyl (3-(hydroxymethyl)acrylate), p-cyanophenyl (meth)acrylate, o-cyanophenyl (meth)acrylate, m-cyanophenyl (meth)acrylate, 5-(meth)acryloyl-2-carbonitrilanarbornene, 6-(meth)acryloyl-2-carbonitrilonorbomene, 1-cyano-1-(meth)acryloylcyclohexane, 1,1-dimethyl-1-cyano(meth)acrylate, 1-dimethyl-1-ethyl-1-cyano(meth)acrylate, o-cyanobenzyl (meth)acrylate, m-cyanobenzyl (meth)acrylate, p-cyanobenzyl (meth)acrylate, 1-cyanocycloheptyl acrylate, 2-cyanophenyl acrylate, 3-cyanophenyl acrylate, vinyl cyanoacetate, vinyl 1-cyano-1-cyclopropanecarboxylate, allyl cyanoacetate, allyl 1-cyano-1-cyclopropanecarbaxylate, N,N-dicyanomethyl (meth)acrylamide, N-cyanophenyl (meth)acrylamide, allyl cyanomethyl ether, allyl-o-cyanoethyl ether, allyl-m-cyanobenzyl ether, allyl-p-cyanobenzyl ether, and the like.
Monomers having a structure in which a part of the hydrogen atoms of the above-mentioned monomers have been substituted by a hydroxyl group, an alkoxy group, a halogen, a cyano group or the like, may also be used.
Polymerization may be carried out using the method described in Lectures on Experimental Chemistry "Polymer Chemistry," Chapter 2-2 (p. 34), or the general radical polymerization method described in "Experimental Methods for Polymer Synthesis," written by Otsu Takayuki, Chapter 5 (p. 125). Known examples of the initiator for radical polymerization include a high-temperature initiator which requires heating to 100°C or above, an ordinary initiator which initiates by heating at 40 to 100°C, a redox initiator which initiates at very low temperature, and the like. However, an ordinary initiator is preferred from the viewpoint of easy handlability of polymerization reactions.
Examples of the ordinary initiator include benzoyl peroxide, lauroyl peroxide, peroxodisulfuric acid salts, azobisisobutyronitrile, and azabis-2,4-dimethylvaleronitrile.

2) Case where the polymerization mode for forming the polymer main chain is identical with the polymerization mode for the polymerizable group to be introduced into a side chain

Examples of the case where the polymerization mode for forming the polymer main chain is identical with the polymerization mode for the polymerizable group to be introduced into a side chain, include: 2-1) an aspect in which both polymerization models involve cationic polymerization; and 2-2) an aspect in which both polymerization modes involve radical polymerization.

2-1) Aspect in which both polymerization modes involve cationic polymerization

According to the aspect in which both polymerization modes involve cationic polymerization, the same monomers as those used for forming a cyano group-containing unit mentioned for the aspect of (1-1) may be used as the monomer having a cyano group.

From the viewpoint of preventing gelation during polymerization, it is preferable to use a method of preliminarily synthesizing a polymer having a cyano group, subsequently reacting the polymer with a compound having a cationically polymerizing polymerizable group (hereinafter, appropriately referred to as "reactive compound"), and thereby introducing a cationically polymerizing polymerizable group into a side chain.

It is preferable that the polymer having a cyano group have a reactive group such as shown below, for the reaction with the reactive compound.

It is also preferable to appropriately select the polymer having a cyano group and the reactive compound, so as to form combinations of functional groups described below.

Specific examples of the combination include (reactive group of polymer, functional group of reactive compound) = (carboxyl group, carboxyl group), (carboxyl group, epoxy group), (carboxyl group, isocyanate group), (carboxyl group, halogenated benzyl), (hydroxyl group, carboxyl group), (hydroxyl group, epoxy group), (hydroxyl group, isocyanate group), (hydroxyl group, halogenated benzyl), (isocyanate group, hydroxyl group), (isocyanate group, carboxyl group), and the like.

Here, specifically, compounds shown below may be used as the reactive compound.

That is, the compounds include allyl alcohol, 4-hydroxybutane vinyl ether, 2-hydroxyethane vinyl ether, 3-hydroxypropane vinyl ether, hydroxytriethylene glycol vinyl ether, 1st terpionel, 2-methyl-2-propenol, 3-methyl-3-butenol, 3-methylene-2-hydroxynorbomane, and p-(chloromethyl)styrene.

2-2) Aspect in which both polymerization modes involve radical polymerization

According to the aspect in which both polymerization modes involve radical polymerization, examples of the synthesis method include: i) a method of copolymerizing a monomer having a cyano group and a monomer having a polymerizable group; ii) a method of copolymerizing a monomer having a cyano group and a monomer having a double bond precursor, and then introducing a double bond by treating the product with a base or the like; and iii) a method of reacting a polymer having a cyano group with a monomer having a polymerizable group, and thereby introducing a double bond (introducing a polymerizable group). Preferred methods from the viewpoint of synthesis suitability are ii) a method of copolymerizing a monomer having a cyano group and a monomer having a double bond precursor, and then introducing a double bond by treating the product with a base or the like, and iii) a method of reacting a polymer having a cyano group with a monomer having a polymerizable group, and thereby introducing a polymerizable group.

Examples of the monomer having a polymerizable group that is used in the synthesis method of (i) include allyl (meth)acrylate, and the following compounds.

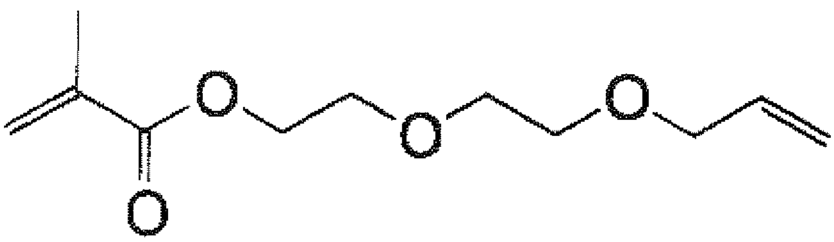

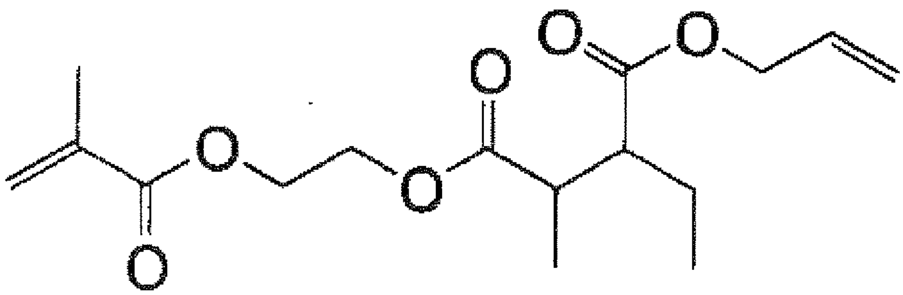

Examples of the monomer having a double bond precursor that is used in the synthesis method of (ii) include compounds represented by the following formula (a), and the like.

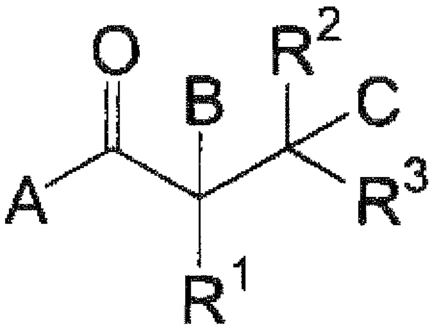

Formula (a)

In formula (a), A represents an organic atomic group having a polymerizable group; $R^1$ to $R^3$ each independently represent a hydrogen atom, or a monovalent organic group; and B and C each represent an elimination group that is removed by an elimination reaction. The elimination reaction as used herein means that C is detached under the action of base, and B is eliminated. It is preferable that B be eliminated as an anion, and C be eliminated as a cation. Specific examples of the compound represented by the formula (a) include the following compounds.

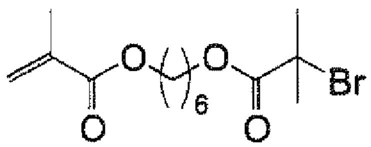

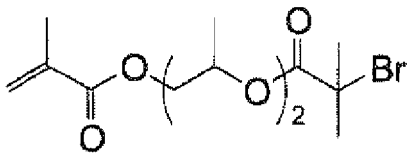

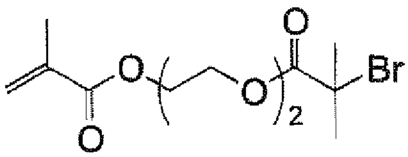

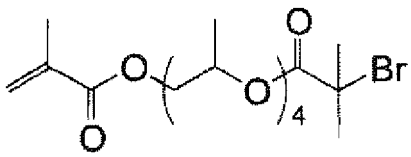

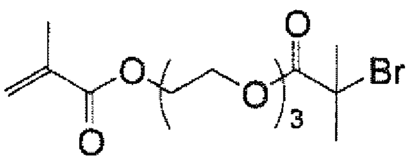

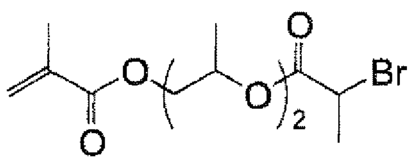

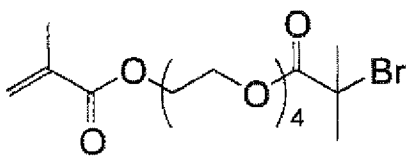

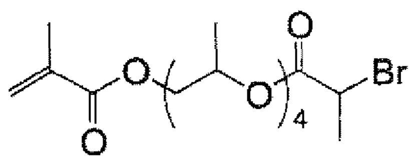

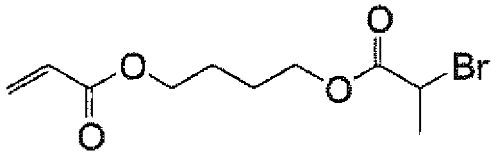

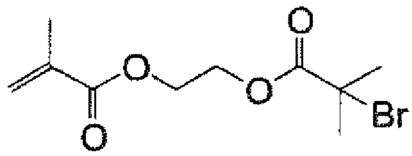

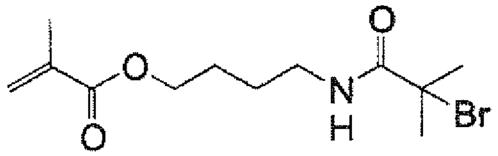

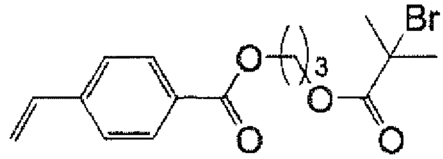

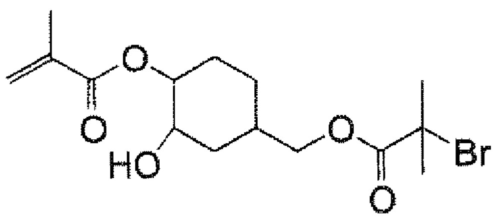

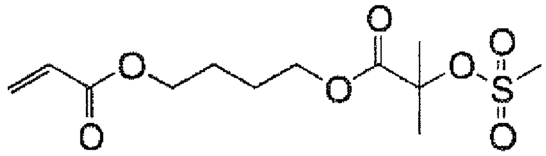

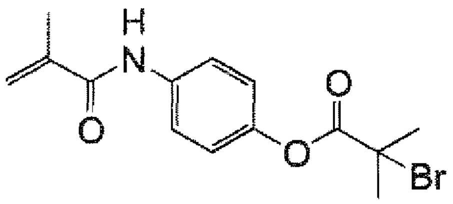

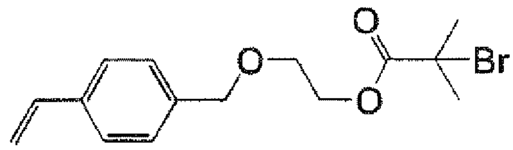

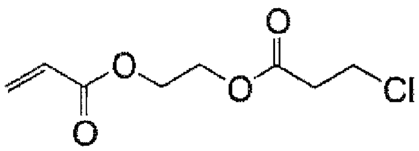

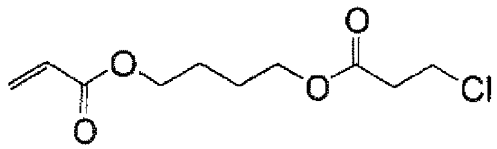

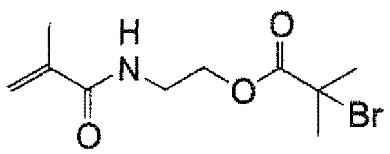

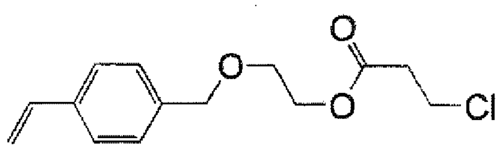

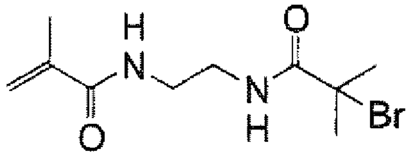

Furthermore, in order to convert the double bond precursor to a double bond in the synthesis method of (ii), a method of removing the elimination groups represented by B and C through elimination reactions as described below, that is, a reaction of detaching C under the action of base and eliminating B is used.
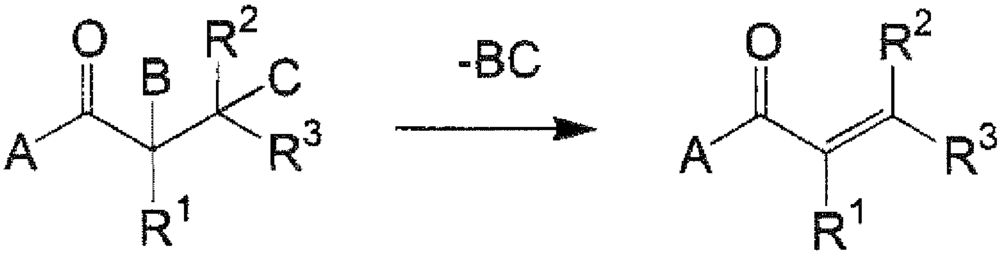


Preferred examples of the base used in the elimination reaction mentioned above include hydrides, hydroxides or carbonates of alkali metals, organic amine compounds, and metal alkoxide compounds. Preferred examples of the hydrides, hydroxides or carbonates of alkali metals include sodium hydride, calcium hydride, potassium hydride, sodium hydroxide, potassium hydroxide, calcium hydroxide, potassium carbonate, sodium carbonate, potassium hydrogen carbonate, sodium hydrogen carbonate, and the like. Preferred examples of the organic amine compounds include trimethylamine, triethylamine, diethylmethylamine, tributylamine, triisobutylamine, trihexylamine, trioctylamine, N,N-dimethylcyclohexylamine, N,N-diethyleyelohexylamine, N-znethyldicyelohexylamine, N-ethyldicyclohexylamine, pyrrolidine, 1-methylpyrrolidine, 2.5-dimethylpyrrolidine, piperidine, 1-methylpiperidine, 2,2,6,6-tetramethylpiperidine, piperazine, 1,4-dimethylpiperazine, quinuclidine, 1,4-diazabicycio[2,2,2]-octane, hexamethylenetetramine, morpholine, 4-methylmorpholine, pyridine, picoline, 4-dimethylaminopyridine, lutidine, 1,8-diazabicyclo[5,4,0]-7-undecene (DBU), N,N'-dicyclohexylcarbodiimide (DCC), diisopropylethylamine, Schiff base, and the like. Preferred examples of the metal alkoxide compounds include sodium methoxide, sodium ethoxide, potassium t-butoxide, and the like. These bases maybe used singly or as mixtures of two or more kinds.
Furthermore, examples of the solvent used upon applying (adding) a base to the elimination reaction, include ethylene dichloride, cyclohexanone, methyl ethyl ketone, acetone, methanol, ethanol, propanol, butanol, ethylene glycol monomethyl ether, ethylene glycol monoethyl ether, 2-methoxyethyl acetate, 1-methoxy-2-propanol, 1-methoxy-2-propyl acetate, N,N-dimethylforznamide, N,N-dimethylacetamide, dimethylsulfoxide, toluene, ethyl acetate, methyl lactate, ethyl lactate, water, and the like. These solvents may be used singly or as mixtures of two or more kinds.
The amount of the base used may be an equivalent or less, or may be an equivalent or more, relative to the amount of the specific functional groups (elimination groups represented by B and C) in the compound. When the base is used in excess, it is also a preferable aspect to add an acid or the like for the purpose of eliminating the excess base after the elimination reaction.
The polymer having a cyano group that is used in the synthesis method of (iii), is synthesized by radical polymerizing the monomer used for forming a cyano group-containing unit that has been mentioned in the aspect of (1-2), and a monomer having a reactive group for introducing a double bond.
The monomer having a reactive group for introducing a double bond may be a monomer having a carboxyl group, a hydroxyl group, an epoxy group or an isocyanate group as the reactive group.
Examples of the carboxyl group-containing monomer include (meth)acrylic acid, itaconic acid, vinyl benzoate; ARONIX M-5300, M-5400 and M-5600 (trade names, manufactured by Toagosei Co., Ltd.); acrylic esters, PA and HH (trade names, manufactured by Mitsubishi Rayon Co., Ltd.); light acrylate, HOA-HH (trade name, manufactured by Kyoeisha Chemical Co., Ltd.); NK ESTER SA and A-SA (trade names, manufactured by Nakamura Chemical Industry Co., Ltd.); and the like.
Examples of the hydroxyl group-containing monomer that may be used include 2-hydroxyethyl (meth)acrylate, 4-hydroxybutyl (meth)acrylate, 2-hydroxypropyl (meth)acrylate, 2-hydroxybutyl (meth)acrylate, 1-(meth)acryloyl-3-hydroxyadamantane, hydroxymethyl (meth)acrylamide, 2-(hydroxymethyl)-(meth)acrylate, methyl ester of 2-(hydroxymethyl)-(meth)acrylate, 3-chloro-2-hydroxypropyl (meth)acrylate, 3,5-dihydroxypentyl (meth)acrylate, 1-hydroxymethyl-4-(meth)acryloylmethyl-cyclohexane. 2-hydroxy-3-phenoxypropyl (meth)acrylate, 1-methyl-2-acryloyloxypropylphthalic acid, 2-acryloyloxyethyl-2-hydroxyethylphthalic acid, 1-methyl-2-acryloyloxyethyl-2-hydroxypropylphthalic acid, 2-acryloyloxyethyl-2-hydroxy-3-chloropropylphthalic acid; ARONIX M-554, M-154, M-555, M-155 and M-158 (trade names, manufactured by Toagosei Co., Ltd.); BLENMER PE-200, PE-350, PP-500, PP-800, PP-1000, 70PEP-350B and 55PET800 (trade names, manufactured by Nippon Oil & Fats Co., Ltd.); and a lactone-modified acrylate having the following structure.

$$CH_2\text{-}CRCOOCH_2CH_2[OC(=O)C_5H_{10}]_nOH$$

(wherein R = H or Me, and n = 1 to 5)

Examples of the monomer having an epoxy group that may be used include glycidyl (meth)acrylate, CYCLOMER A and M (trade names, manufactured by Daicel Chemical Industries, Ltd.), and the like.

Examples of the monomer having an isocyanate group that may be used include KARENZ AOI and MOI (trade names, manufactured by Showa Denko K.K.).

Furthermore, the polymer having a cyano group that is used in the synthesis method of (iii) may further contain a third copolymer component.

The monomer having a polymerizable group which is reacted with a polymer having a cyano group in the synthesis method of (iii), may vary with the type of the reactive group in the polymer having a cyano group, but monomers having functional groups of the following combinations may be used.

That is, the combinations include (reactive group of polymer, functional group of monomer) = (carboxyl group, carboxyl group), (carboxyl group, epoxy group), (carboxyl group, isocyanate group), (carboxyl group, halogenated benzyl), (hydroxyl group, carboxyl group), (hydroxyl group, epoxy group), (hydroxyl group, isocyanate group), (hydroxyl group, halogenated benzyl), (isocyanate group, hydroxyl group), (isocyanate group, carboxyl group), (epoxy group, carboxyl group), and the like.

Specifically, the following monomers may be used.

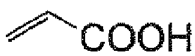
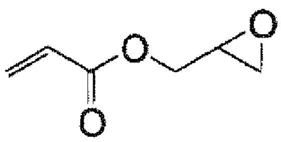
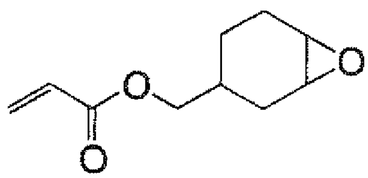

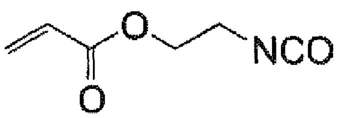
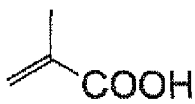
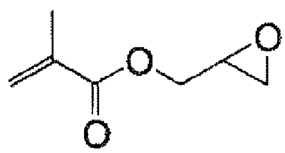

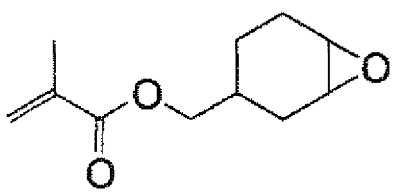
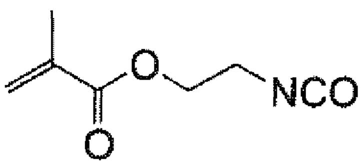

In regard to the cyano group-containing polymerizable polymer according to the invention, when $L^1$ in the formula (1), formula (3) or formula (4) is a divalent organic group having a urethane bond, it is preferable to carry out synthesis by the synthesis method described below (hereinafter, referred to as synthesis method A).

That is, the synthesis method A according to the invention is characterized by forming a urethane bond in $L^1$ by using at least a polymer having a hydroxyl group in a side chain and a compound having an isocyanate group and a polymerizable group in a solvent to add the isocyanate group to the hydroxyl group.

Here, the polymer having a hydroxyl group in a side chain that is used in the synthesis method A, is preferably a copolymer of the monomer used for forming a cyano group-containing unit mentioned in the aspect of (1-2), and a hydroxyl group-containing (meth)acrylate shown below.

As the hydroxyl group-containing (meth)acrylate, the monomers of the same type as the hydroxyl group-containing monomers mentioned as an example of the aforementioned monomer having a reactive group for introducing a double bond, may be used.

In addition, the polymer having a hydroxyl group in a side chain that is used in the synthesis method A may further contain a third copolymerization component.

Among the polymers having a hydroxyl group in a side chain as described above, use may be made of a polymer synthesized using a raw material from which a bifunctional acrylate that is side-produced upon synthesis of the hydroxyl group-containing (meth)acrylate has been removed, as the raw material, from the viewpoint of synthesizing a polymer having a high molecular weight. The method for purification of the hydroxyl group-containing (meth)acrylate is preferably distillation or column purification. More preferably, it is preferable to use a hydroxyl group-containing (meth) acrylate obtained by sequentially going through the following steps (I) to (IV):

(I) Dissolving a mixture containing a hydroxyl group-containing (meth)acrylate and a bifunctional acrylate that is side-produced upon synthesizing the hydroxyl group-containing (meth)acrylate, in water;
(II) Adding a first organic solvent that separates from water, to the obtained aqueous solution, and then separating the phase containing the first organic solvent and the bifunctional acrylate from the aqueous phase;
(III) Dissolving a compound having higher water-solubility than that of the hydroxyl group-containing (meth)acrylate, in the aqueous phase; and
(IV) Extracting the hydroxyl group-containing (meth)acrylate by adding a second organic solvent to the aqueous phase, and then concentrating the extract.

The mixture used in the step of (I) contains a hydroxyl group-containing (meth)acrylate and a bifunctional acrylate, which is an impurity that is side-produced upon synthesizing the hydroxyl group-containing (meth)acrylate, and the mixture corresponds to a common commercially available product of hydroxyl group-containing (meth)acrylate.

In the step of (I), this commercially available product (mixture) is dissolved in water, and thereby an aqueous solution is obtained.

In the step of (II), a first organic solvent that separates from water is added to the aqueous solution obtained in the step of (I). Examples of the first organic solvent used herein include ethyl acetate, diethyl ether, benzene, toluene and the like.

Subsequently, the phase containing this first organic solvent and the bifunctional acrylate (oil phase) is separated from the aqueous solution (aqueous phase).

In the step of (III), a compound having higher water-solubility than that of the hydroxyl group-containing (meth) acrylate is dissolved in the aqueous phase separated from the oil phase in the step of (II).

As the compound having higher water-solubility than that of the hydroxyl group-containing (meth)acrylate used herein, inorganic salts, such as alkali metal salts such as sodium chloride and potassium chloride, and alkaline earth metal salts such as magnesium sulfate and calcium sulfate, are used.

In the step of (IV), the hydroxyl group-containing (meth)acrylate is extracted by adding a second organic solvent to the aqueous phase, and then the extract is concentrated.

Examples of the second organic solvent used herein include ethyl acetate, diethyl ether, benzene, toluene, and the like. This second organic solvent may be identical with the first organic solvent mentioned above, or may be different from the first organic solvent.

Drying over anhydrous magnesium sulfate, elimination by distillation under reduced pressure and the like are used for the concentration in the step of (IV).

The isolation product containing the hydroxyl group-containing (meth)acrylate obtained by sequentially going through the steps of (I) to (IV), preferably contains the bifunctional acrylate in an amount in the range of 0.1% by mass or less based on the total mass of the isolation product. That is, by going through the steps of (I) to (IV), the impurity bifunctional acrylate is removed from the mixture, and thereby the hydroxyl group-containing (meth)acrylate is purified. A more preferred range of the content of the bifunctional acrylate is 0.05% by mass or less based on the total mass of the isolation product, and a smaller content is better.

When the hydroxyl group-containing (meth)acrylate thus purified is used, it is difficult for the impurity bifunctional acrylate to exert influence on the polymerization reaction. Thus, a nitrile group-containing polymerizable polymer having a weight average molecular weight of 20000 or greater may be synthesized.

As the hydroxyl group-containing (meth)acrylate used in the step of (I), use may be made of those mentioned as the hydroxyl group-containing (meth)acrylate used upon synthesizing the polymer having a hydroxyl group in a side chain, which is used in the synthesis method A described above. Among them, a monomer having a primary hydroxyl group is preferred from the viewpoint of reactivity to isocyanate, and furthermore, a hydroxyl group-containing (meth) acrylate having a molecular weight of 100 to 250 is preferred from the viewpoint of increasing the ratio of the polymerizable group per unit weight of the polymer.

Examples of the compound having an isocyanate group and a polymerizable group, which is used in the synthesis method A, include 2-acryloyloxyethyl isocyanate (trade name: KARENZ AOI, manufactured by Showa Denko K.K.), 2-methacryloxy isocyanate (trade name: KARENZ MOI, manufactured by Showa Denko K.K.), and the like.

The solvent used in the synthesis method A is preferably a solvent having an SP value (calculated by the Okitsu method) of 20 $MPa^{1/2}$ to 23 $MPa^{1/2}$, and specific examples include ethylene glycol diacetate, diethylene glycol diacetate, propylene glycol diacetate, methyl acetoacetate, ethyl acetoacetate, 1,2,3-triacetoxypropane, cyclohexanone, 2-(1-cyclohexenyl)cyclohexanone, propionitrile, N-methylpyrrolidone, dimethylacetamide, acetylacetone, acetophenone, triacetin, 1,4-dioxane, dimethyl carbonate, and the like.

Among them, the solvent is more preferably an ester-based solvent, from the viewpoint of synthesizing a high molecular weight product, and particularly, diacetate-based solvents such as ethylene glycol diacetate and diethylene glycol diacetate, and dimethyl carbonate are more preferred.

Here, the SP value of a solvent according to the invention is a value calculated by the Okitsu method (Okitsu, Toshinao, "Journal of the Adhesion Society of Japan," 29(3) (1993)). Specifically, the SP value is a value calculated by the following formula. Here, $\Delta F$ is a value described in the literature.

$$\text{SP value } (\delta) = \Sigma\Delta F \text{ (Molar Attraction Constants)}/V \text{ (molar volume)}$$

The cyano group-containing polymerizable polymer according to the invention that is synthesized as described above, is such that the proportions of the polymerizable group-containing unit and the cyano group-containing unit based on the total amount of the copolymerization components are preferably in the following range.

That is, the polymerizable group-containing unit is preferably contained at a proportion of 5% by mole to 50% by mole, and more preferably 5% by mole to 40% by mole, based on the total amount of the copolymerization components. When the proportion is 5% by mole or less, reactivity (curability, polymerizability) is deteriorated. When the proportion is 50% by mole or more, the copolymer is prone to undergo gelation upon synthesis, and it is difficult to synthesize the copolymer.

The cyano group-containing unit is preferably contained at a proportion of 5% by mole to 95% by mole, and more preferably 10% by mole to 95% by mole, based on the total amount of the copolymerization components, from the viewpoint of absorbability to the plating catalyst.

Furthermore, the cyano group-containing polymerizable polymer according to the invention may further contain another unit in addition to the cyano group-containing unit and the polymerizable group-containing unit. Any monomer, so long as the monomer does not impair the effects of the invention, may be used as a monomer which is used for forming this other unit.

The monomer used for forming the other unit may be, specifically, a monomer capable of forming a main chain skeleton such as an acrylic resin skeleton, a styrene resin skeleton, a phenolic resin (phenol-formaldehyde resin) skeleton, a melamine resin (a polycondensation product of melamine and formaldehyde) skeleton, a urea resin (a polycondensation product of urea and formaldehyde) skeleton, a polyester resin skeleton, a polyurethane skeleton, a polyimide skeleton, a polyolefin skeleton, a polycycloolefin skeleton, a polystyrene skeleton, a polyacrylic skeleton, an ABS resin (a polymer of acrylonitrile, butadiene and styrene) skeleton, a polyamide skeleton, a polyacetal skeleton, a polycarbonate skeleton, a polyphenylene ether skeleton, a polyphenylene sulfide skeleton, a polysulfone skeleton, a polyether sulfone skeleton, a polyallylate skeleton, a polyether ether ketone skeleton or a polyamideimide skeleton.

These main chain skeletons may also be the main chain skeleton of the cyano group-containing unit or the polymerizable group-containing unit.

However, when a polymerizable group is introduced into the polymer through a reaction as described above, if it is difficult to introduce 100% of the polymerizable group, a small amount of the reactive moiety remains behind, so that this may be a third unit.

Specifically, in the case of forming the polymer main chain by radical polymerization, unsubstituted (meth)acrylic acid esters such as ethyl (meth)acrylate, butyl (meth)acrylate, hexyl (meth)acrylate, 2-ethylhexyl (meth)acrylate, cyclohexyl (meth)acrylate, benzyl (meth)acrylate and stearyl (meth)acrylate; halogen-substituted (meth)acrylic acid esters such as 2,2,2-trifluoroethyl (meth)acrylate, 3,3,3-trifluoropropyl (meth)acrylate and 2-chloroethyl (meth)acrylate; ammonium group-substituted (meth)acrylic acid esters such as 2-(meth)acryloyloxyethyltrimethylammonium chloride; (meth)acrylamides such as butyl (meth)acrylainide, isopropyl (meth)acrylamide, octyl (meth)acrylamide and dimethyl (meth)acrylamide; styrenes such as styrene, vinylbenzoic acid and p-vinylbenzylammonium chloride; vinyl compounds such as N-vinylcarbazole, vinyl acetate, N-vinylacetamide and N-vinylcaprolactam; as well as dimethylaminoethyl (meth)acrylate, diethylaminoethyl (meth)acrylate, 2-ethylthioethyl (meth)acrylate, (meth)acrylic acid, 2-hydroxyethyl (meth)acrylate, and the like may be used.
Furthermore, use may also be made of macromonomers obtained by using the monomers described above.

In the case of forming the polymer main chain by cationic polymerization, vinyl ethers such as ethyl vinyl ether, butyl vinyl ether, isobutyl vinyl ether, cyclohexyl vinyl ether, ethylene glycol vinyl ether, di(ethylene glycol) vinyl ether, 1,4-butanediol vinyl ether, 2-chloroethyl vinyl ether, 2-ethylhexyl vinyl ether, vinyl acetate, 2-vinyloxytetrahydropyrane, vinyl benzoate and vinyl butyrate; styrenes such as styrene, p-chlorostyrene and methoxystyrene; and terminal ethylenes such as allyl alcohol and 4-hydroxy-1-butene may be used.

The weight average molecular weight of the cyano group-containing polymerizable polymer according to the invention is preferably from 1000 to 700,000, and more preferably from 2000 to 200,000. Particularly, from the viewpoint of polymerization sensitivity, the weight average molecular weight of the cyano group-containing polymerizable polymer according to the invention is preferably 20,000 or greater.
In regard to the degree of polymerization of the cyano group-containing polymerizable polymer according to the invention, it is preferable to use a polymer having 10-mers or more, and more preferably 20-mers or more. Furthermore, a polymer having 7000-mers or fewer, more preferably 3000-mers or fewer, even more preferably 2000-mers or fewer, and particularly preferably 1000-mers or fewer.
Preferable ranges for the molecular weight and degree of polymerization described herein are suitable ranges also for the specific polymerizable compound, other than the cyano group-containing polymerizable polymer used in the invention.

Specific examples of the cyano group-containing polymerizable polymer according to the invention will be presented below, but the invention is not intended to be limited to these.
In addition, the weight average molecular weights of these specific examples are all in the range of 3000 to 100,000.

Polymers obtained by the aspect (1-1)

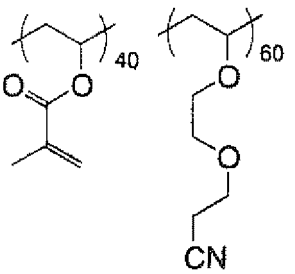
1-1-1

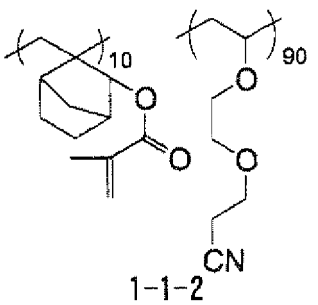
1-1-2

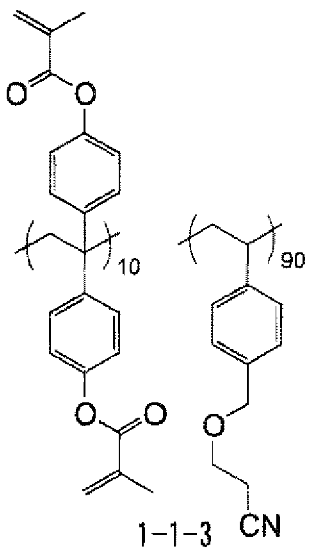
1-1-3

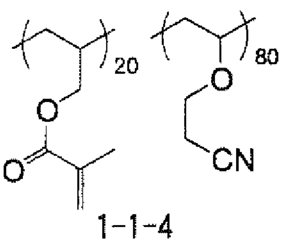
1-1-4

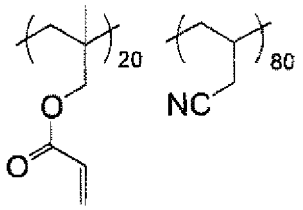
1-1-5

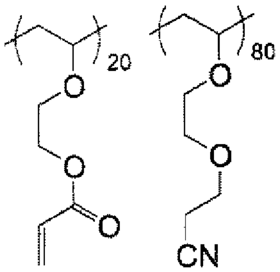

1-1-6

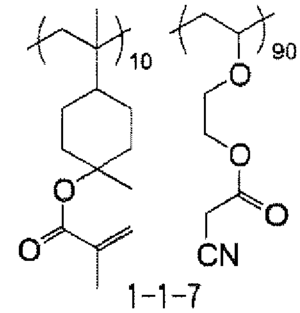

1-1-7

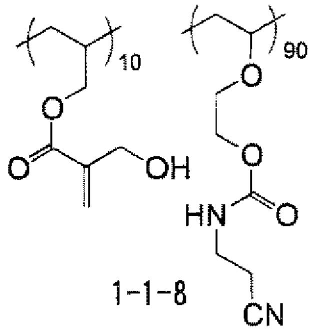

1-1-8

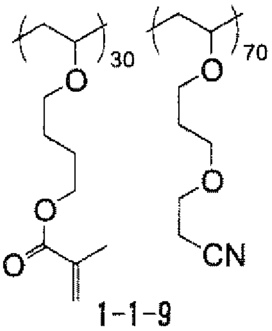

1-1-9

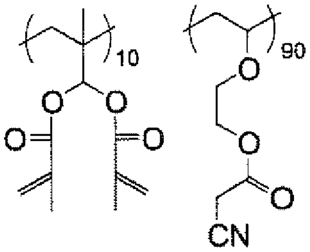

1-1-10

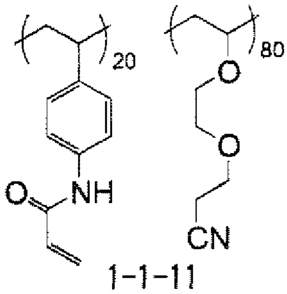

1-1-11

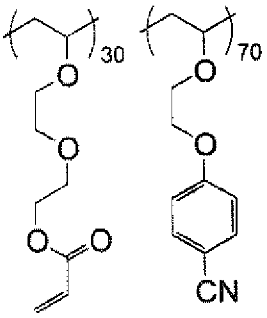

1-1-12

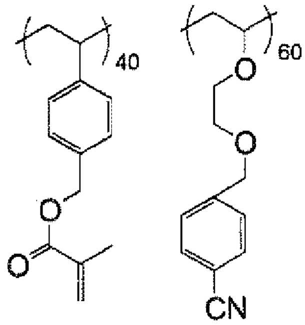

1-1-13

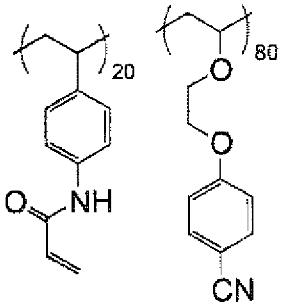

1-1-14

Polymers obtained by the aspect (1-2)

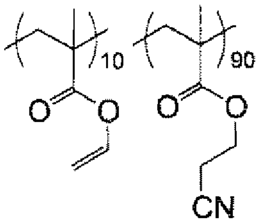

1-2-1

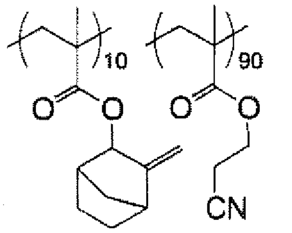

1-2-2

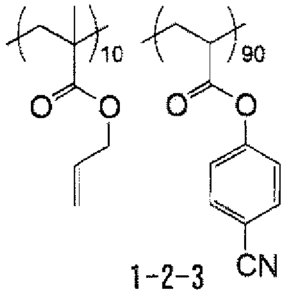

1-2-3

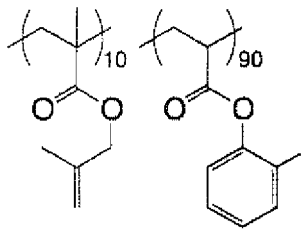

1-2-4

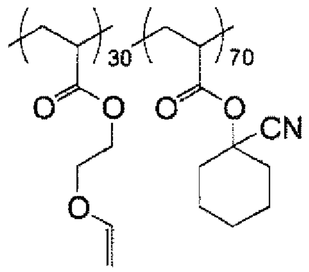

1-2-5

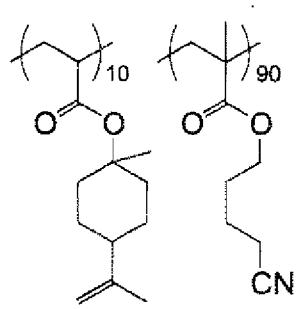

1-2-6

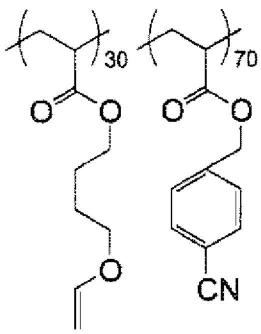

1-2-7

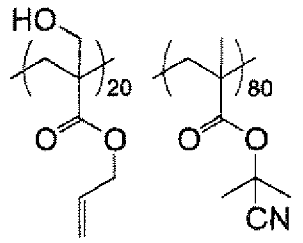

1-2-8

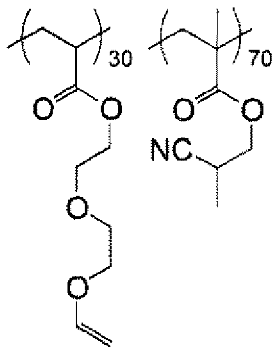

1-2-9

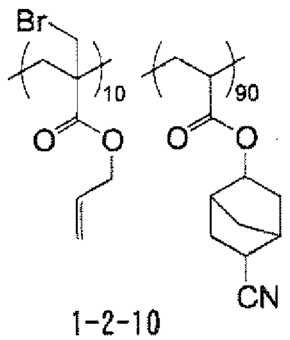

1-2-10

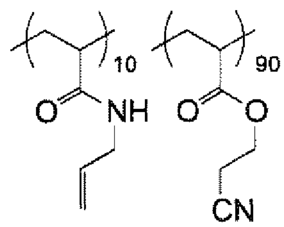

1-2-11

Polymers obtained by the aspect (2-1)

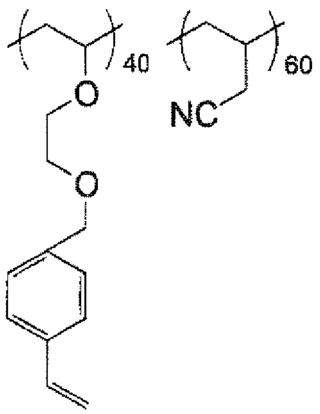

2-1-1

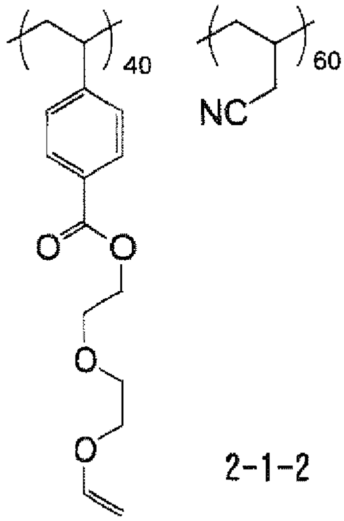

2-1-2

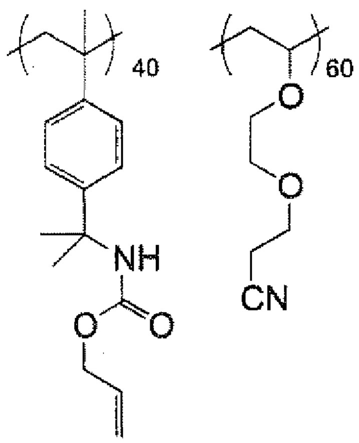

2-1-3

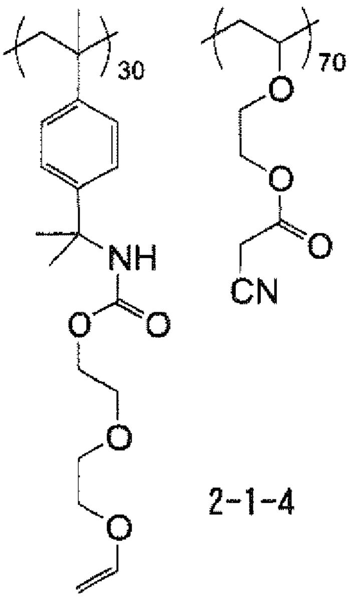

2-1-4

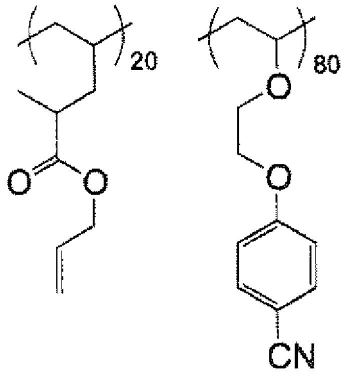

2-1-5

Polymers obtained by the aspect (2-2)

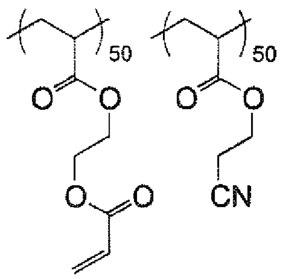

2-2-1

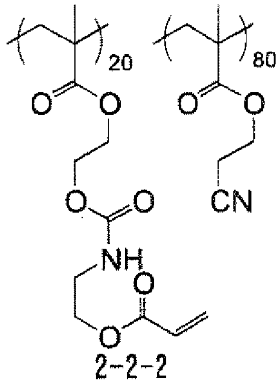

2-2-2

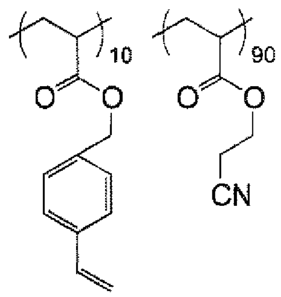

2-2-3

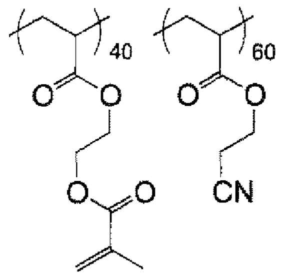

2-2-4

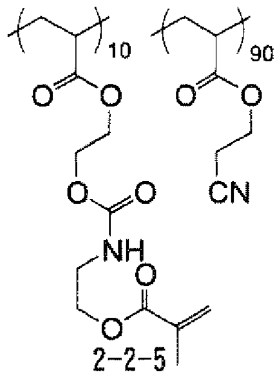

2-2-5

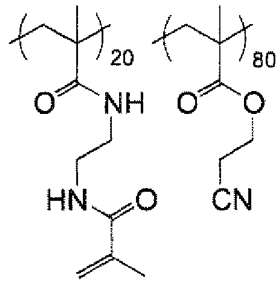

2-2-6

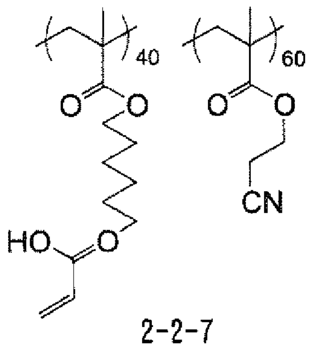

2-2-7

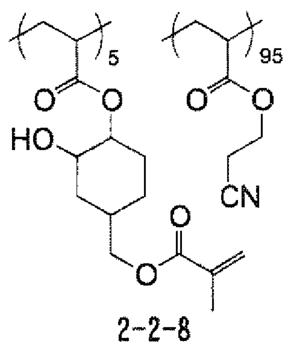

2-2-8

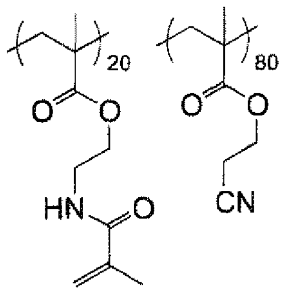

2-2-9

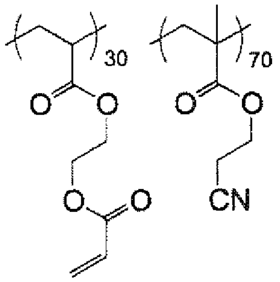

2-2-10

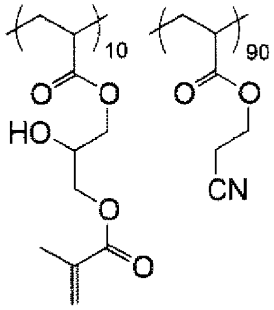

2-2-11

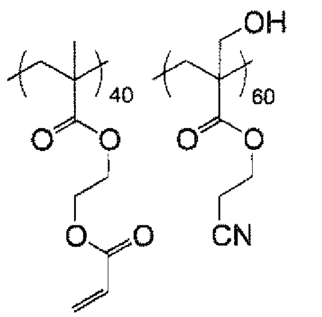

2-2-12

Polymers obtained by the aspect (2-2)

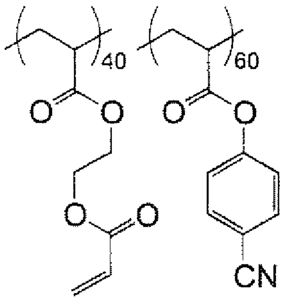

2-2-13

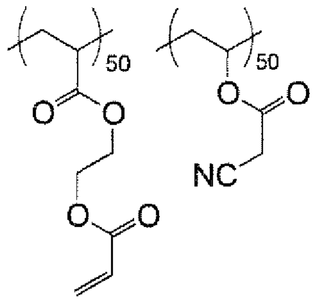

2-2-14

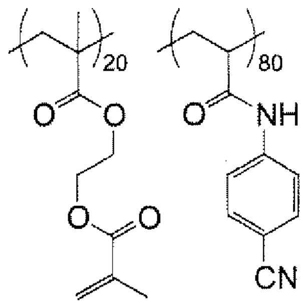

2-2-15

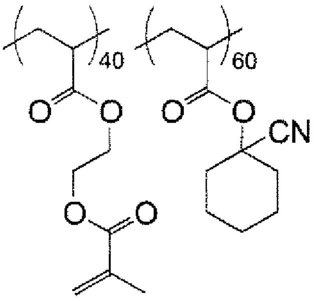

2-2-16

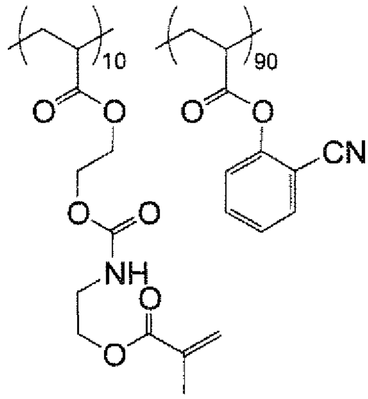

2-2-17

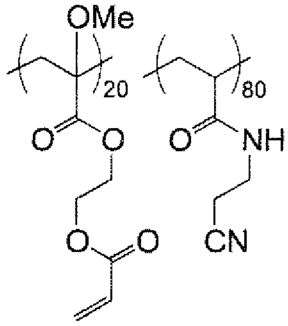

2-2-18

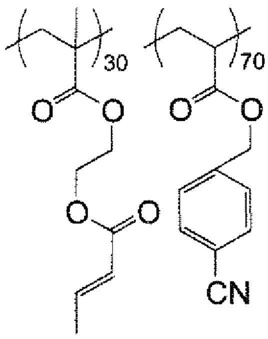

2-2-19

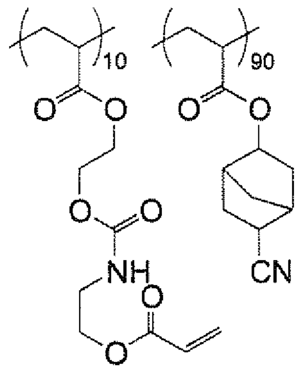

2-2-20

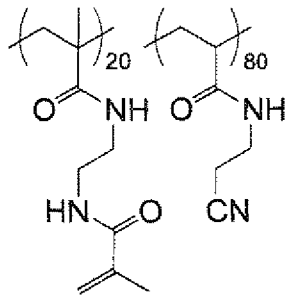

2-2-21

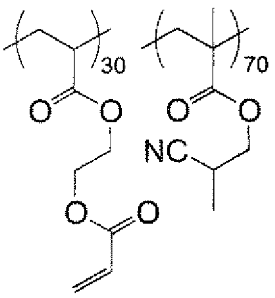

2-2-22

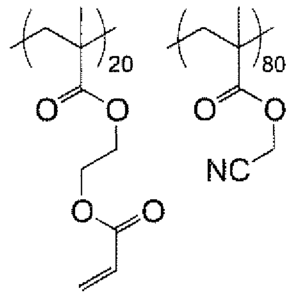

2-2-23

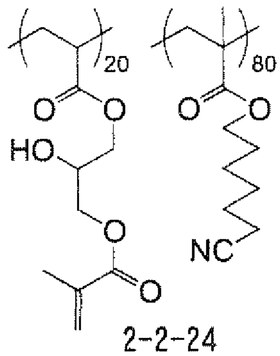

2-2-24

Polymers obtained by the aspect (2-2)

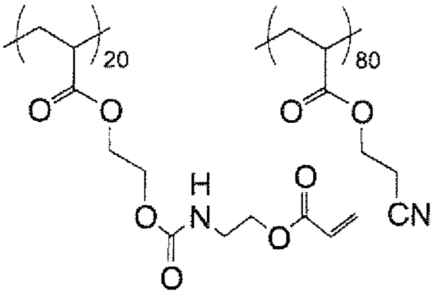

2-2-25

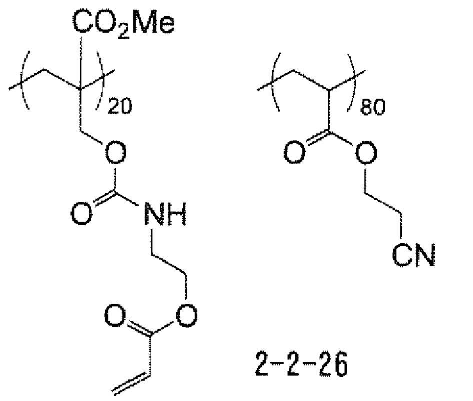

2-2-26

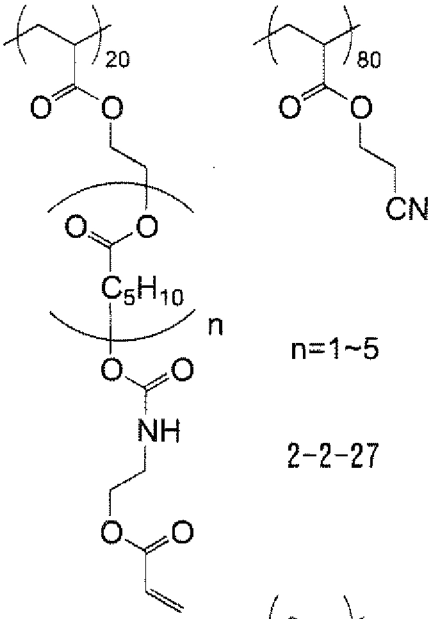

n=1~5

2-2-27

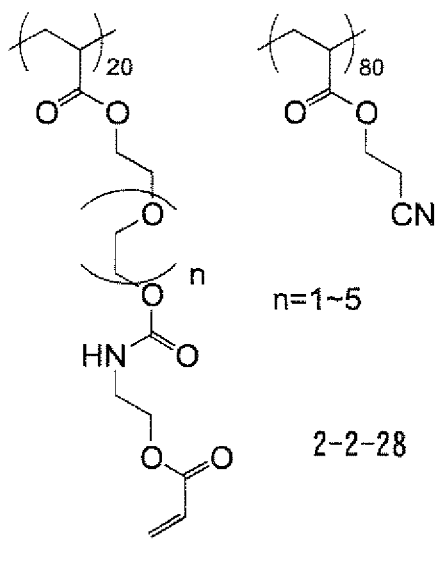

n=1~5

2-2-28

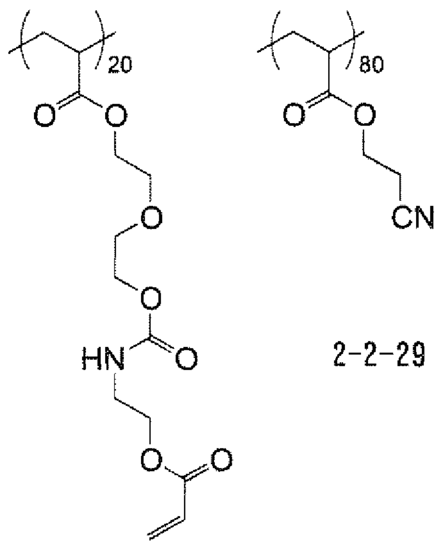

2-2-29

Polymers obtained by the aspect (2-2)

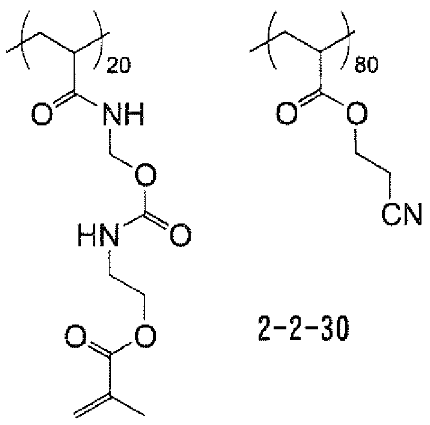

2-2-30

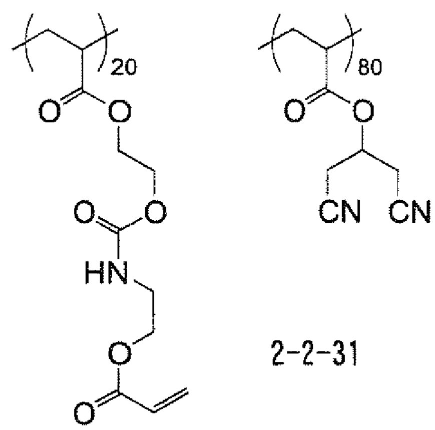

2-2-31

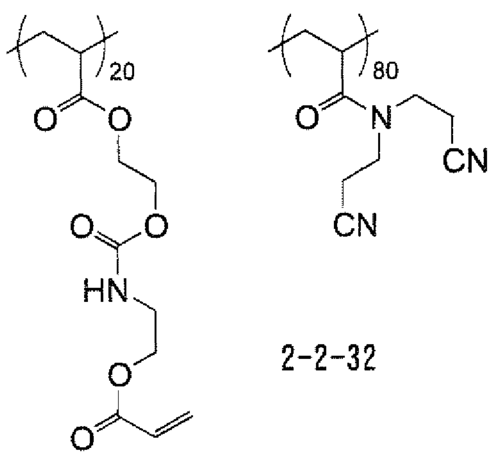

2-2-32

Here, for example, compound 2-2-11 of the specific examples may be synthesized by dissolving acrylic acid and 2-cyanoethyl acrylate in, for example, N-methylpyrrolidone, performing radical polymerization using, for example, azoisobutyronitrile (AIBN) as a polymerization initiator, and then subjecting the resulting polymer to an addition reaction with glycidyl methacrylate using a catalyst such as benzyltriethylammonium chloride, in a state of having a polymerization inhibitor such as tertiary-butylhydroquinone.
In addition, for example, compound 2-2-19 of the specific examples may be synthesized by dissolving the monomer shown below and p-cyanobenzyl acrylate in a solvent such as N,N-dimethylacrylamide, performing radical polymerization using a polymerization initiator such as dimethyl azoisobutyrate, and then dehydrochlorinating the resulting polymer using a base such as triethylamine.

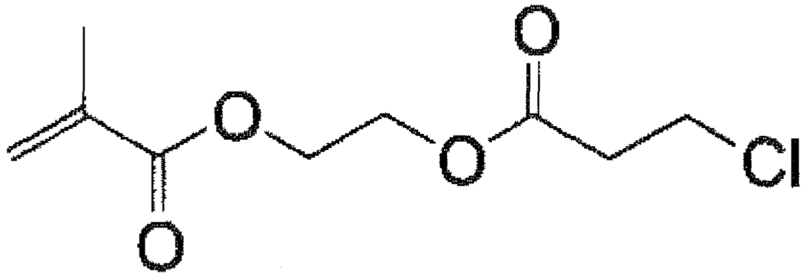

The compound having an interactable group and a polymerizable group according to the invention, such as the cyano group-containing polymerizable polymer, may also have a polar group in addition to the polymerizable group and interactable group.
When the compound has a polar group, in the case of providing, for example, a protective layer after a plating film has been formed, the adhesive power at the contact area of the polymer layer and the protective layer may be enhanced.
In order to form a polymer layer as described above, it is preferable to use a liquid composition containing a compound having an interactable group and a polymerizable group, such as a polymer having an interactable group and a polymerizable group, that is, a composition containing a compound having an interactable group and a polymerizable group, and a solvent capable of dissolving the compound (preferably, the composition for polymer layer formation of the invention including a polymer having a cyano group or a structure represented by $-O-(CH_2)_n-O-$ (wherein n is an integer from 1 to 5), and a polymerizable group, and solvent capable of dissolving the polymer).
The content of the compound having an interactable group and a polymerizable group (for example, the cyano group-containing polymerizable polymer) in the composition is preferably 2% by mass to 50% by mass, based on the whole composition.
The solvent used in the composition is not particularly limited, if the compound having an interactable group and a polymerizable group, which is a main component of the composition, can be dissolved therein. The solvent may be further added with a surfactant.
Examples of the solvent that may be used include alcohol-based solvents such as methanol, ethanol, propanol, ethylene glycol, glycerin and propylene glycol monomethyl ether; acids such as acetic acid; ketone-based solvents such as acetone, methyl ethyl ketone and cyclohexanone; amide-based solvents such as formamide, dimethylacetamide and N-methylpyrrolidone; nitrile-based solvents such as acetonitrile and propylonitrile; ester-based solvents such as methyl acetate and ethyl acetate; carbonate-based solvents such as dimethyl carbonate and diethyl carbonate; and the like.
Among these, in the case of a composition making use of a cyano group-containing polymerizable polymer, amide-based, ketone-based, nitrile-based solvents and carbonate-based solvents are preferred, and specifically, acetone, dimethylacetamide, methyl ethyl ketone, cyclohexanone, acetonitrile, propionitrile, N-methylpyrrolidone and dimethyl carbonate are preferred.
Furthermore, in the case of coating a composition containing a cyano group-containing polymerizable polymer, a solvent having a boiling point of 50°C to 150°C is preferred from the viewpoint of easy handlability. These solvents may be used singly, or may be used as mixtures.
According to the invention, in the case of coating the composition containing a compound having an interactable group and a polymerizable group on a base material, a solvent may be selected such that a solvent absorption ratio of the base material (polymerization initiating layer) of 5% to 25% is obtained. This solvent absorption ratio may be determined from the changes in mass, which is obtained by submerging the base material having the polymerization initiating layer formed thereon into the solvent, and pulling it out after 1000 minutes.
In the case of coating the composition containing a compound having an interactable group and a polymerizable group on a base material, a solvent may also be selected such that a swelling ratio of the base material (polymerization initiating layer) of 10% to 45% is obtained. This swelling ratio may be determined from the changes in thickness, which is obtained by submerging the base material into the solvent, and pulling it out after 1000 minutes.
The surfactant that may be added to the solvent as necessary may be any solvent that is dissolved in the solvent, and examples of such a surfactant include anionic surfactants such as sodium n-dodecyl benzenesulfonate; cationic surfactants such as n-dodecyltrimethylammonium chloride; nonionic surfactants such as polyoxyethylene nonyl phenol ether (commercially available products include, for example. EMULGEN 910 manufactured by Kao Corp.; and the like), polyoxyethylene sorbitan monolaurate (commercially available products include, for example, "TWEEN 20 (trade name)" and the like), and polyoxyethylene lauryl ether; and the like.
Furthermore, a plasticizer may also be added, if necessary. For the plasticizer that may be used, common plasticizers may be used, and phthalic acid esters (dimethyl ester, diethyl ester, dibutyl ester, di-2-ethylhexyl ester, di-normal-octyl ester, diisononyl ester, dinonyl ester, diisodecyl ester, butyl benzyl ester), adipic acid esters (dioctyl ester, diisononyl ester), dioctyl azelate, sebacic acid esters (dibutyl ester, dioctyl ester), and high boiling point solvents such as tricresyl phosphate, tributyl acetylcitrate, epoxidated soybean oil, trioctyl trimellitate, chlorinated paraffins, dimethylacetamide and N-methylpyrrolidone may also be used.

The composition containing the compound having an interactable group and a polymerizable group may contain a polymerization inhibitor as necessary. Examples of the polymerization inhibitor that may be used include hydroquinones such as hydroquinone, di-tertiary-butylhydroquinone and 2,5-his(1,1,3,3-tetrarnethylhutyl)hydroquinone; phenols such as p-methoxyphenol and phenol; benzoquinones; free radicals such as TEMPO (2,2,6,6-tetramethyl-1-piperidinyloxy free radical) and 4-hydroxy TEMPO; phenothiazines; nitrosoamines such as N-nitrosophenylhydroxyamine and aluminum salt thereof; and catechols.

The composition containing the compound having an interactable group and a polymerizable group may contain, if necessary, a curing agent and/or a curing accelerating agent so as to allow curing of the polymerization initiating layer to proceed. Examples of the curing agent and/or curing accelerating agent in the case where an epoxy compound is contained in the polymerization initiating layer, include, as for the polyaddition type, aliphatic polyamine, alicyclic polyamine, aromatic polyamine, polyamide, acid anhydride, phenol, phenol novolac, polymercaptan, a compound having two or more active hydrogen atoms, and the like; and as for the catalyst type, aliphatic tertiary-amine, aromatic tertiary-amine, an imidazole compound, a Lewis acid complex, and the like.

Furthermore, examples of such an agent that initiates curing under the action of heat, light, moisture, pressure, acid, base or the like, include diethylenetriamine, triethylenetetramine, tetraethylenepentamine, diethylaminopropylamine, polyamidoamine, menthenediamine, isophoronediamine, N-aminoethylpiperazine, 3,9-bis(3-aminopropyl)-2,4,8,10-tetraoxyspiro(5,5)undecane adduct, bis(4-amino-3-methylcyclohexyl)methane, bis(4-aminocyclohexyl)methane, m-xylenediamine, diaminodiphenylmethane, m-phenylenediamine, diaminodiphenylsulfone, dicyandiamide, adipic acid dihydrazide, phthalic anhydride, tetrahydrophthalic anhydride, hexahydrophthalic anhydride, methyltetrahydrophthalic anhydride, methylhexahydrophthalic anhydride, methylnadic anhydride, dodecylsuccinic anhydride, chlorendic anhydride, pyromellitic anhydride, benzophenone tetracarboxylic acid anhydride, ethylene glycol bis(anhydrotrimate), methylcyclohexene tetracarboxylic acid anhydride, trimellitic anhydride, polyazelaic acid anhydride, phenol novolac, xylylene novolac, bis A novolac, triphenylmethane novolac, biphenyl novolac, dicyclopentadiene phenol novolac, terpene phenol novolac, polymercaptan, polysulfide, 2,4,6-tris(dimethylaminomethyl)phenol, 2,4,6-tris(dimethylaminomethyl) phenol-tri-2-ethylhexanoic acid salt, benzyldimethylamine, 2-(dimethylaminomethyl)phenol 2-methylimidazole, 2-ethyl-4-methylimidazole 2-undecylimidazole, 2-heptadecylimidazole, 2-phenylimidazole, 1-benzyl-2-methylimidazole, 1-cyanocthyl-2-methylimidazole, 2,4-diamino-6-(2-methylimidazolyl-(1))-ethyl S-triazine, a $BF_3$-monoethylamine complex, a Lewis acid complex, an organic acid hydrazide, diaminomaleonitrile, a melamine derivative, an imidazole derivative, a polyamine salt, an amineimide compound, an aromatic diazonium salt, a diallyliodonium salt, a triallylsulfonium salt, a triallylselenium salt, a ketimine compound, and the like.

These curing agents and/or curring accelerating agents are preferably added in an amount of about 0% by mass to 50% by mass of the non-volatile components remaining after the solvent has been removed, from the viewpoints of the coatability of the solution, adhesiveness to the base material or the plating film, and the like. The curing agent and/or curing accelerating agent may be added to the polymerization initiating layer, and in that case, it is preferable that the amount of the agent(s) added to the polymerization initiating layer and the total amount of the agent(s) added to the resin layer satisfy the range mentioned above.

Furthermore, a rubber component (for example, CTBN), a flame retardant (for example, a phosphorus-based flame retardant), a diluent or a thixotropic agent, a pigment, a defoaming agent, a leveling agent, a coupling agent and the like may also be added. These additives may be added to the polymerization initiating layer according to necessity.

When a composition prepared by appropriately mixing such a compound having an interactable group and a polymerizable group with various additives is used, properties of the formed polymer layer, for example, coefficient of thermal expansion, glass transition temperature, Young's modulus, Poisson's ratio, rupture stress, yield stress, thermal degradation temperature and the like may be optimally set up. Particularly, in regard to the rupture stress, yield stress and thermal degradation temperature, higher values are more preferable.

The thermal durability of the obtained polymer layer may be measured by a temperature cycle test, a heat time test, a reflow test or the like, and for example, in regard to thermal degradation, the polymer layer may be evaluated to have sufficient thermal durability, if the mass reduction occurring upon exposure to an environment at 200°C for one hour is 20% or less.

When the composition containing the compound having an interactable group and a polymerizable group is contacted, the amount of coating thereof is preferably 0.1 $g/m^2$ to 10 $g/m^2$, and particularly preferable 0.5 $g/m^2$ to 5 $g/m^2$, in terms of the solids content, from the viewpoint of the properties for the formation of sufficient interaction between the composition and the plating catalyst or a precursor thereof.

When a layer containing a compound having an interactable group and a polymerizable group is formed by applying and drying the composition containing the compound having an interactable group and a polymerizable group on a base

material, the applied composition may be left to stand at 20°C to 40°C for 0.5 hours to 2 hours between the application and drying, to thereby remove any remaining solvent.

(Application of energy)

The method of applying energy to the surface of the base material may utilize, for example, irradiation of radiation such as heating or exposure. For example, photo-irradiation using a UV lamp, visible light or the like; heating with a hot plate; and the like may be made possible. Examples of the light source include a mercury lamp, a metal halide lamp, a xenon lamp, a chemical lamp, a carbon arc lamp, and the like. Examples of radiation include electron beams, X-rays, ion beams, far-infrared rays, and the like. Furthermore, g-rays, i-rays, deep-UV light, or high-density energy beams (laser beams) may also be used.
Specific suitable aspects that are generally used include direct imagewise recording by a thermal recording head or the like, scan exposure by an infrared laser, high-illuminance flash exposure by a xenon discharge lamp or the like, infrared lamp exposure, and the like.
The time required for energy application may vary with the amount of production of the intended graft polymer and the light source, but the time is usually between 10 seconds and 5 hours.
When the application of energy is carried out by exposure, the exposure power is preferably in the range of 10 $mJ/cm^2$ to 5000 $mJ/cm^2$, and more preferably in the range of 50 $mJ/cm^2$ to 3000 $mJ/cm^2$, so as to carry out graft polymerization easily, and to suppress degradation of the produced graft polymer.
Furthermore, if a polymer having an average molecular weight of 20,000 or more and a degree of polymerization of 20-mers or more is used as the compound having an interactable group and a polymerizable group, graft polymerization may be easily carried out with low-energy exposure, and therefore, degradation of the produced graft polymer may be further suppressed.
As described above, an object to be plated having a specif polymer layer formed on the surface of a base material, may be obtained.
If the obtained polymer layer is such that, for example, the progress of degradation at the polymerizable group site is 50% or less after the polymer layer has been added to an alkaline solution at pH 12 and stirred for one hour, the polymer layer may be subjected to washing with a highly alkaline solution.
The polymer that is not bound to the base material may be removed by the techniques shown below. For example, physical methods for removal include an atmospheric pressure plasma method, a wet blast method and the like. Also, regarding a chemical method for removal, a solvent in which the specific polymer is likely to undergo swelling and peeling may be used, and examples of this solvent include acetone, acetonitrile, dimethylcellosolve, ethylene glycol dimethyl ether, methyl acetoacetate, cyclohexanone, dimethyl carbonate, as well as aqueous solutions thereof, and the like.

[Plating catalyst liquid]

In the step (a) according to the invention, use is made of a plating catalyst liquid containing a catalytic element and an organic solvent (plating catalyst liquid of the invention).
When this plating catalyst liquid is applied onto the aforementioned object to be plated, the catalytic element applied thereto attaches (adsorbs) to the functional group capable of forming an interaction with the catalytic element present at the surface of the object to be plated (interactable group).
The catalytic element constituting the plating catalyst liquid according to the invention may be an element that serves as an active core or functions as an electrode, at the time of plating that is carried out in the step (b) that will be described later.
The catalytic element is not particularly limited as long as it is capable of serving as an active core or functioning as an electrode, and examples include Pd, Ag, Cu, Ni, Al, Fe, Co and the like. Among them, an element capable of polydentate coordination is preferred, and particularly from the viewpoints of the number of types of the functional group capable of coordination and the extent of the catalytic capacity, Pd is particularly preferred.
The catalytic element in the plating catalyst liquid according to the invention exists in the form of ions, in the form of metal microparticles, or in the form of colloid (metal colloid).
The metal colloid, which is a form of existence for the catalytic element in the plating catalyst liquid, may be produced generally by reducing the metal ions in a solution containing a charged surfactant or a charged protective agent. The charge of the metal colloid may be regulated by means of the surfactant or protective agent used herein.
A plating catalyst liquid having the catalytic element present in the form of ions, may be produced by using a metal salt. The metal salt being used is not particularly limited if the salt dissolves in an appropriate solvent and dissociates into metal ions and a base (anions), and examples include $M(NO_3)_n$, $MCl_n$, $M_{2/n}(SO_4)$, $M_{3/n}(PO_4)$ (wherein M represents an n-valent metal atom), and the like.

According to the invention, examples of the organic solvent used in the plating catalyst liquid include ketone-based solvents such as acetone; nitrile-based solvents such as acetonitrile; alcohol-based solvents such as methanol; amide-based solvents such as dimethylfomamide; and the like. Among them, acetone and methanol are preferred, and acetone is particularly preferred, in view of easy removability.

As the liquid component that constitutes the plating catalyst liquid according to the invention, water (distilled water) may be used in addition to the organic solvents mentioned above.

The content ratio of water and the organic solvent in the plating catalyst liquid is preferably in the range of water:organic solvent = 5:95 to 95:5 by mass, and particularly, from the viewpoint that the rate at which the catalytic element attaches to the object to be plated is increased, it is desirable to have more of the organic solvent relative to water. Specifically, the ratio by mass of water:organic solvent is more preferably in the range of 10:90 to 30:70, and even more preferably in the range of 20:80 to 35:65.

Concerning the method of applying the plating catalyst liquid onto the object to be plated, the plating catalyst liquid may be coated on the surface of the object to be plated, or the object to be plated may be immersed into the plating catalyst liquid.

In the case of using a surface graft polymerization method upon obtaining the object to be plated, a composition containing a compound having an interactable group and a polymerizable group is contacted on top of the base material; however, a method of adding a catalytic element to this composition in advance may also be used. When a composition containing a catalytic element and a compound having an interactable group and a polymerizable group is contacted on top of the base material, and a surface graft polymerization method is applied, there may be formed a polymer layer containing a catalytic element and a polymer which has an interactable group and is directly chemically bonded to the base material. When this object to be plated having a polymer layer is further immersed into the plating catalyst liquid described above, a larger amount of the catalytic element may be incorporated into the polymer layer.

Furthermore, if the base material is a resin film, and specific polymer layers have been formed on both surfaces of the resin film, it is preferable to use the immersion method as described above, in order to simultaneously bring the plating catalyst liquid to contact with the polymer layers on both surfaces.

When the plating catalyst liquid is contacted with the object to be plated as described above, the catalytic element may be adsorbed to the interactable group present at the surface of the object to be plated, by utilizing an interaction based on the intermolecular force such as van der Waals force, or an interaction based on coordinate bonding through lone pair electrons.

From the viewpoint of sufficiently achieving such adsorption, the concentration of the catalytic element in the plating catalyst liquid is preferably in the range of 0.001% by mass to 50% by mass, and more preferably in the range of 0.005% by mass to 30% by mass. The contact time is preferably about 30 seconds to 24 hours, and more preferably about 1 minute to 1 hour.

[Step (b)]

In the step (b) according to the invention, the object to be plated to which the plating catalyst liquid has been applied in the step (a) described above, is subjected to plating. Thereby, a plating film is formed on the object to be plated. The formed plating film has excellent electrical conductivity and adhesiveness.

The types of the plating performed in the present step include electroless plating, electroplating, and the like, and the type of plating may be selected based on the function of the plating catalyst within the plating catalyst liquid applied in the step (a).

That is, in the present step, the object to be plated to which the plating catalyst liquid has been applied may be subjected to electroplating, or may be subjected to electroless plating.

Among others, according to the invention, when the object to be plated has a specific polymer layer, it is preferable to carry out electroless plating, in view of the properties for the formation of a hybrid structure that is exhibited in the polymer layer, and an enhancement of adhesiveness. According to a more preferred aspect, electroplating is further carried out after the electroless plating, so as to obtain a plating film with a desired thickness.

Plating that is suitably carried out in the present step will be explained below.

(Electroless plating)

Electroless plating means an operation of precipitating metal through a chemical reaction, using a solution having dissolved therein the ions of a metal that is wished to be precipitated as plating.

Electroless plating in the present step is carried out by, for example, washing the object to be plated to which the plating catalyst liquid has been applied, with water to remove any excess catalytic element (metal), and then submerging the object to be plated into an electroless plating bath. A generally known electroless plating bath may be used as the electroless plating bath used herein.

When the catalytic element is applied to the object to be plated in the form of metal ions, an electroless plating bath containing a reducing agent is used. By using such an electroless plating bath, the metal ions are reduced, and subsequently, electroless plating is carried out.
Reduction of the metal ions may also be carried out as a separate process prior to electroless plating, by preparing a catalyst activating liquid (reducing liquid), apart from the aspect of using such an electroless plating liquid as described above. The catalyst activating liquid is a liquid prepared by dissolving a reducing agent that is capable of reducing metal ions to zero-valent metal, and the concentration may be of 0.1% to 50%, and preferably 1% to 30%. For the reducing agent, a boron-based reducing agent such as sodium borohydride or dimethylamineborane, or a reducing agent such as formaldehyde or hypophosphorous acid may be used.

The composition of a general electroless plating bath mainly contains, in addition to the solvent, (1) metal ions for plating, (2) a reducing agent, (3) an additive that enhances the stability of the metal ions (stabilizer). This plating bath may also contain, in addition to these, known additives such as a stabilizer for plating bath.
According to the invention, it is preferable to use a water-based electroless plating bath, from the viewpoint of suppressing environmental burden. Here, it is meant by the water-based electroless plating bath according to the invention that the bath contains 50% by mass or more of water (distilled water) as a liquid component.

However, concerning an object to be plated showing high hydrophobicity, an organic solvent may also be added to the plating bath to an extent that the organic solvent does not make the amount of water to deviate from the range mentioned above.
The organic solvent used in the plating bath is required to be a solvent that is miscible with water, and from that point of view, ketones such as acetone, and alcohols such as methanol, ethanol and isopropanol are preferably used.

The types of the metal used in the electroless plating bath that are known include copper, tin, lead, nickel, gold, palladium and rhodium, and among them, copper and gold are particularly preferred from the viewpoint of electrical conductivity.
Furthermore, there are available reducing agents and additives that are optimal for the metals mentioned above. For example, an electroless plating bath for copper contains $CuSO_4$ as a copper salt; HCOH as a reducing agent; and as additives, EDTA as a stabilizer for copper ions or a chelating agent such as Rochelle's salt, trialkanolamine and the like. A plating bath used in the electroless plating of CoNiP contains cobalt sulfate and nickel sulfate as metal salts; sodium hypophosphite as a reducing agent, sodium malonate, sodium malate and sodium succinate as complexing agents. Furthermore, an electroless plating bath for palladium contains $(Pd(NH_3)_4)Cl_2$ as a metal ion; $NH_3$ and $H_2NNH_2$ as reducing agents; and EDTA as a stabilizer. These plating baths may also contain other components in addition to the above components.

The thickness of the plating film thus formed by electroless plating may be controlled by means of the metal ion concentration in the plating bath, the duration of immersion into the plating bath, temperature of the plating bath or the like, but from the viewpoint of electrical conductivity, the thickness is preferably 0.5 μm or greater, and more preferably 3 μm or greater.
The duration of immersion into the plating bath is preferably about 1 minute to 6 hours, and more preferably about 1 minute to 3 hours.

It was confirmed with regard to the plating film obtained by electroless plating the object to be plated having a specific polymer layer as described above, that when the plating film was cross-sectionally observed by SEM, microparticles formed from the catalytic element or the plating metal were densely dispersed in the specific polymer layer, and furthermore, the plating metal was precipitated out onto the surface of the polymer layer. Since the interface between the object to be plated and the plating film adopts a hybrid state of the polymer and the microparticles, even though the interface between the polymer layer (organic component) and the inorganic matter (catalytic element or plating metal) is smooth (for example, the height of unevenness is 500 nm or less), the adherence becomes satisfactory.

(Electroplating)

According to the present step, when the catalytic element applied in the step (a) has a function as an electrode, the object to be plated to which the plating catalyst liquid has been applied, may be subjected to electroplating.
Furthermore, after the electroless plating described above, electroplating may be further carried out using the formed plating film as an electrode. Thereby, an electroless plating film having excellent adhesiveness to the object to be plated may be used as a base, and a new metal film having any thickness may be easily formed thereon. As such, when electroplating is carried out after electroless plating, a metal film may be formed to an intended thickness according to the purpose, and therefore, the metal film of the invention may be applied to various applications.

As the method of electroplating according to the invention, a conventionally known method may be used. Furthermore, examples of the metal used in the electroplating of the present step include copper, chromium, lead, nickel, gold, silver, tin, zinc and the like, and from the viewpoint of electrical conductivity, the metal is preferably copper, gold or silver, and more preferably copper.

The thickness of the metal film obtainable by electroplating varies in accordance with the use, and the thickness may be controlled by adjusting the metal concentration contained in the plating bath, current density or the like. In addition, in the case of using the metal film in general electrical wiring or the like, the thickness is preferably 0.5 μm or greater, and more preferably 3 μm or greater, from the viewpoint of electrical conductivity.

In the case of using an object to be plated having a specific polymer layer for the invention, the adhesiveness between the metal film and the polymer layer may be further enhanced, when the metal derived from the catalytic element and/or the metal precipitated inside the polymer layer as a result of electroless plating forms a fractal-shaped microstructure within the polymer layer.

In regard to the amount of metal present in the specific polymer layer, when the cross-section of the object to be plated is photographed under a metallurgical microscope, the proportion of the metal occupying a region that extends from the outermost surface of the polymer layer to a depth of 0.5 μm is 5% by area to 50% by area. When the arithmetic average roughness Ra (JIS B 0633-2001) of the interface between the polymer layer and the metal is 0.05 μm to 0.5 μm, stronger adhesive power is exhibited.

As explained above, when the steps (a) and (b) are carried out, a plating film (metal thin film) is formed on the surface of the object to be plated. The formed plating film (metal thin film) has excellent adhesiveness to the object to be plated, and may be applied to various uses such as, for example, electromagnetic wave shielding films, coating films, bilayer CCL materials, and materials electrical wiring.

The plating film obtained by the plating method of the invention (metal thin film obtained by the method for forming a metal thin film of the invention) may be produced into a metal pattern, by etching the plating film into a pattern form.

This (c) etching step will be explained below.

[Step (c)]

In the step (c), when the plating film (metal thin film) obtained by the plating method of the invention is etched into a pattern form, unnecessary parts of the plating film are removed, and a desired metal pattern may be obtained.

The formation of this metal pattern may make use of any available technique, and specifically, a subtractive method and a semi-additive method, which are generally known, are used.

The subtractive method is a method for forming a metal pattern by providing a dry film resist layer on a plating film that has been formed, performing pattern exposure and development to form the same pattern as a metal pattern section, and removing the plating film using the dry film resist pattern as a mask and an etching liquid. Any material may be used for the dry film resist, and any negative type, positive type, liquid or film-like materials may be used. For the etching method, any of methods that are being used upon the production of printed wiring boards may be used, and wet etching, dry etching or the like may be used. The etching method may be arbitrarily selected. In view of workability of the operation, wet etching makes use of convenient instruments and thus is preferable. Examples of the etching liquid that may be used include aqueous solutions of cupric chloride, ferric chloride and the like.

The semi-additive method is a method for forming a metal pattern by providing a dry film resist layer on a plating film that has been formed, performing pattern exposure and development to form the same pattern as the non-metal pattern section, performing electroplating while using the dry film resist pattern as a mask, removing the dry film resist pattern, subsequently performing quick etching, and removing the plating film in a pattern form. The same materials as those used in the subtractive method may be used for the dry film resist, etching liquid and the like. Furthermore, the techniques described above may be used for the electroplating technique.

As the above steps (a) to (c) are carried out, a desired metal pattern may be obtained.

On the other hand, in the case of an object to be plated having a specific polymer layer, a plating film of a desired pattern may be obtained by preliminarily forming the specific polymer layer in a pattern form, and subjecting such an object to be plated to the step (b) described above (full additive process).

In regard to the method for forming a specific polymer layer in a pattern form, specifically, the energy that is applied upon forming the polymer layer may be applied in a pattern form. Furthermore, when the areas where energy is not applied are removed by development, a pattern-shaped polymer layer may be formed.

The development method is carried out by immersing the polymer layer in a solvent which is capable of dissolving the material used to form the polymer layer, such as the compound having an interactable group and a polymerizable group. The immersion time is preferably 1 minute to 30 minutes.

The pattem-shaped specific polymer layer may also be directly patterned by a known coating method such as a gravure printing method, an inkjet method or a spray coating method making use of a mask, subsequently applying energy, and then performing development.

The step (b) for forming a plating film on the pattern-formed polymer layer is carried out in the same manner as the method described above.

The metal pattern thus obtained is preferably such that the metal film (plating film) has been provided on an

object to be plated having an unevenness of the surface of 500 nm or less (more preferably, 100 nm or less), over the entire surface thereof or partially. It is also preferable that the adhesiveness between the object to be plated and the metal pattern be 0.2 kN/m or greater. That is, the invention is **characterized in that** while the surface of the object to be plated is smooth, the adhesiveness between the object to be plated and the metal pattern is excellent.

The unevenness of the surface of the object to be plated is a value measured by cutting the object to be plated in a direction perpendicular to the surface of the object to be plated, and observing the cross-section by SEM.

More particularly, the unevenness corresponds to Rz as measured according to JIS B 0601, that is, the "difference between the average value of Z data for the highest peak to the fifth highest peak, and the average value of Z data for the lowest valley to the fifth lowest valley in a defined plane," and is preferably 500 nm or less.

The value of adherence between the object to be plated and the plating film is a value obtainable by adhering a copper plate (thickness: 0.1 mm) to the surface of the plating film (metal pattern) with an epoxy-based adhesive (trade name: ARALDITE, manufactured by Ciba Geigy K.K.), drying the assembly at 140°C for 4 hours, and then performing a 90° peel-off test based on JIS C 6481; or by directly peeling off the end parts of the plating film, and performing a 90° peel-off test based on JIS C 6481.

The metal pattern thus obtained may be applied to various applications such as, for example, semiconductor chips, various electrical wiring boards, FPC, COF, TAB, antennas, multilayer wiring boards, and main boards.

A printed wiring board having a metal pattern obtainable by the method for forming a metal thin film of the invention, and a method for producing a multilayer wiring board using the printed wiring board will be specifically described below.

A multilayer wiring board is generally formed by laminating plural electrical wirings, with insulating resins interposed therebetween. The techniques for lamination are largely classified into a batch lamination method and a build-up method (or an HDI (High Density Interconnection) method).

The batch lamination method is a method of forming an electrically conductive pattern in the forum of wiring, on the respective surfaces of a substrate having metal thin films or thin films made of an electroconductive material applied on both surfaces (or on one surface), alternately laminating the substrate having wirings made of metal or the like formed on both surfaces (or on one surface) and an insulating resin, and subjecting these to lamination integration by a single press. In this method, conduction of interlayer wirings may be obtained by subjecting the integrated multilayer wiring board to penetrating through-hole processing, and performing through-hole plating of the walls of through-holes, filling of an electroconductive substance or the like.

The build-up method includes a method of disposing a batch laminated board (or one layer of both-sided or single-sided copper-clad substrate with wiring, or the like) at the central area (referred to as base or core), and sequentially stacking up an insulating resin and an electrical wiring thereon to form a multilayer assembly; a method of stacking up a film made of an insulating resin and an electrical wiring in sequence from the beginning; a method of performing electroless plating and electroplating on a film made of an insulating resin and laminated on the core to form a metal thin film; and the like. In these methods, a blind via structure or a buried via structure may be introduced into the multilayer wiring board by performing via-hole processing, in addition to the through-hole processing, at the time point of having layers stacked, and subjecting the via-hole section to plating, filling of an electroconductive substance, or the like. Since the degree of freedom in interlayer connection is increased thereby, this leads to the production of a high-density, high-integrated multilayer wiring board.

A preferable method for forming an interlayer connection structure in the production of such a multilayer wiring board will be described below.

In the case of thraugh-hole processing, a substrate which has been multilayer laminated in advance is provided, through-holes which penetrate through all layers are formed, and interlayer conduction is achieved by plating the inner walls or the interior of the through-holes. The multilayer lamination may be carried out by a batch lamination method or a build-up method.

According to the invention, for example, a plating catalyst liquid is applied on an object to be plated constituted of a base material, a polymerization initiating layer and a specific polymer layer in the step (a), subsequently the object to be plated is plated by electroless plating or electroplating in the step (b), and then a wiring pattern is formed thereon. Thereby, plural sheets of a single-layer wiring substrate having an electrical wiring on both surfaces or on a single surface of an object to be plated, are provided.

Subsequently, the plural sheets of the substrate having a wiring pattern (electrical wiring) formed thereon are integrated by lamination. The lamination may be carried out by fusing the exposed base materials themselves, or by disposing adhesive layers between the substrates and laminating the substrates under pressure.

On the other hand, in the case of via-hole processing, since the processing is carried out by a build-up method, for example, when a core base material, a polymerization initiating layer, a specific polymer layer, a metal thin film, and a layer made of an insulating resin (interlayer insulating layer) are stacked up in sequence, via-holes are formed in each of the layers, and interlayer conduction is achieved by plating the inner walls or the interior of the via-holes.

Techniques for through-hole or via-hole processing include drill cutting, discharge (plasma) processing, laser

processing, photo-via processing which performs exposure and development by photolithography, microblast processing and the like. However, the technique for hole processing is not limited to these, and any technique capable of obtaining a desired processed shape may be used.

In the case of through-hole processing, since the substrate thickness increases as a result of lamination, drill cutting or discharge processing is preferred from the viewpoint of achieving uniform processing. In the case of the build-up method which is advantages in the formation of high-density integrated circuits, discharge (plasma) processing, laser processing, microblast processing or the like may be suitably used to process fine through-holes.

Furthermore, from the viewpoint that the base material residue (smear) which remains in the through-holes and via-holes after the formation of through-holes and via-holes, is reduced, and the smear removal process may be simplified or even omitted, it is preferable to use an excimer laser processing method, if laser processing is to be used, or to use microblast processing.

With regard to the smear removal (desmear) process, in the case of a rigid substrate, known desmear treatment liquid and conditions may be used. For example, MDK series marketed by Muromachi Technos Co., Ltd.; ENPLATE series marketed by Meltex, Inc.; and those marketed by Atotech GmbH may be used. In general, a swelling treatment of the interlayer insulating layers is performed, the smear is oxidatively degraded by using an alkaline permanganate solution or a chromate solution, and neutralization and water washing treatments are carried out.

On the other hand, in the case of using a flexible substrate, for example, polyimide as the base material, the smear may be easily removed by alkali washing.

In the case of performing through-hole and/or via-hole processing in the invention, there is a possibility that the layer exposed as the outermost layer by the desmear process (desmear treatment) may undergo degradation, and thus it is preferable to employ the method described below. However, if the layer exposed as the outermost layer by the desmear process is not much affected, a multilayer wiring board may be obtained according to the method described above.

When the outermost layer is an insulating resin such as an interlayer insulating layer, or a polymerization initiating layer, it is preferable to carry out the desmear process immediately after the through-hole and via-hole process. Thereafter, for example, at the time of forming the polymerization initiating layer or the specific polymer layer, the progress of the reaction (curing) of the composition that forms the polymerization initiating layer or the composition that forms the specific polymer layer is suppressed, and any unreacted matter (uncured matter) is washed, only at the through-hole and/or via-hole areas. Then, desmear-processed through-hole and via-hole surfaces may be exposed. More specifically, the composition that forms the polymerization initiating layer and the composition that forms the specific polymer layer are respectively applied, and then a mask is provided over the through-hole and/or via-hole areas. The composition that forms the polymerization initiating layer and the composition that forms the specific polymer layer are reacted (cured) by photo-irradiation, and then the unreacted matter (uncured matter) present at the areas covered by the mask is washed away. Thus, desmeared through-holes and via-holes may be obtained. At this time, it is preferable that the composition that forms the polymerization initiating layer and the composition that forms the specific polymer layer be reactive (polymerizable) under the action of an active energy other than heat, and it is particularly preferable that the compositions be photosensitive resin compositions.

Furthermore, it is also acceptable to form in advance the polymerization initiating layer or the specific polymer layer in a film form, and to carry out the step for forming through-hole and/or via-hole using a mask while performing lamination under pressure (if necessary, under heating). In this case, in order to remove the polymerization initiating layer and the specific polymer layer inside the masked through-holes, it is preferable to maintain the reaction ratio (polymerization ratio) low in the respective layers which are in the form of film. Furthermore, it is also acceptable to carry out the process by first filling the through-holes with a material that has poor wettability for the polymerization initiating layer and the specific polymer layer (for example, a water-soluble resin composition, or the like), subsequently applying the composition that forms the polymerization initiating layer or the composition that forms the specific polymer layer, allowing the composition to react (cure), and removing the water-soluble resin composition inside the through-holes and via-holes using a water-based washing solution. At this time, the material having poor wettability may be a water-soluble resin composition, and for example, an acrylic acid polymer, a cellulose-based polymer, polyvinyl alcohol or the like may be used. By using these methods, the interior of the through-holes and/or via-holes may be desmear-treated, and a multilayer wiring board having a specific polymer layer may be obtained.

When the base material and the specific polymer layer are directly bound so that the adhesion between the base material and the specific polymer layer is excellent, it is not necessary to form a polymerization initiating layer between the base material and the specific polymer layer. For example, in the case where a functional group is present as a result of roughening or degradation of the base material surface when the base material is desmear-treated, the specific polymer layer may be directly formed thereon without forming a polymerization initiating layer. At this time, from the standpoint of the invention, in regard to the surface roughness Ra ($\mu$m) of the base material surface as a rough guide, if a specific polymer layer having a thickness of Rax2+A ($\mu$m) is applied, the surface of the resin layer underneath the metal wiring may be made smooth again. Here, A is preferably in the range of from 0.05 to 2.

Furthermore, when the specif polymer layer is present at the outermost layer, it is preferable to perform the

through-hole and/or via-hole processing, only after a resist layer for desmear process (desmear resist layer) is applied above the specific polymer. For the desmear resist layer, it is preferable to use a resin that hardly swells with the swelling treatment and is hardly oxidatively degraded by the alkaline permanganate treatment during the desmear treatment. Specific examples include polypropylene, vinyl chloride, polytetrafluoroethylene, syndiotactic polystyrene, epoxy resins, and the like. Particularly, polypropylene, polyvinyl chloride and polyethylene, which are used in reagent containers or the like, are preferred.

When the specific polymer layer still remains even after the desmear treatment is carried out, it is acceptable to carry out the desmear treatment while having the specific polymer layer exposed. For example, the etching rate of the specific polymer layer during the desmear process may be measured in advance, and the specific polymer layer may be applied to a thickness such that the specific polymer layer remains even after the desmear treatment is carried out, as calculated from the time required by the desmear process.

Furthermore, when a metal thin film is present at the outermost surface, the through-hole and/or via-hole processing may suitably utilize a conventional desmear process. In this case, the metal thin film is preferably thin from the viewpoint of processability, and the thickness is preferably 0.1 $\mu$m to 2 $\mu$m. In a preferred aspect according to the invention, the through-hole and via-hole processing is carried out after electroless plating is carried out.

In addition, a base material and a film formed by laminating a polymerization initiating layer, a specific polymer layer and an electroless plating layer may be prepared separately in advance, and all of single-layer substrates may be laminated together by applying a batch lamination method. Alternatively, lamination or transfer may be carried out onto the surface layer of a multilayer substrate which has been laminated in advance and has an insulating base material exposed at the surface.

Through-holes and/or via-holes having the specific polymer layer exposed at the surface are formed by these methods, subsequently the through-holes and/or via-holes are filled with an electroconductive material by known technologies, and then a metal thin film is formed and processed into wiring. Thereby, an interlayer connected multilayer wiring board may be obtained.

Known methods for filling through-holes and/or via-holes include, for example, a method of performing conformal plating on the walls of the through-holes and/or via-holes, subsequently filling the through-holes and/or via-holes with an ink material or an electroconductive paste, and polishing the surface to be smooth; a method of performing conformal plating, and then performing electrofilling plating to fill up the interior of the through-holes and via-holes with metal plating; and the like.

After filling the through-holes and/or via-holes and then further carrying out the formation of a metal thin film and processing into wiring, include the following. In the case of the subtractive method, plating is performed after the filling, the obtained metal thin film is etched, and thereby a wiring is obtained. In the case of the semi-additive method, after the filling, a plating resist is provided before plating is performed, the filled sections and the exposed sections are plated, and then microetching is performed. Thereby, a metal wiring may be formed on the surface of the specific polymer layer. In the case of the full additive method, the specific polymer layer is preliminarily formed in a pattern form, plating is performed with a catalyst applied to the surface of the specific polymer layer as well as the through-holes and via-holes, and thereby a metal wiring is formed. The inner walls of the through-holes and via-holes have, at the surface, a physical anchor or a functional group resulting from resin degradation, as a result of the desmear treatment. Since the catalyst does not attach to the polymerization initiating layer exposed at the outermost layer, which has not been subjected to the desmear treatment, a full additive wiring may be obtained.

Furthermore, the composition that forms the polymerization initiating layer or the composition that forms the specific polymer may be laminated and reacted (cured), after preliminarily filling the inside of the desmear-treated through-holes and via-holes with electroconductive particles or performing conformal plating through a known catalyst application process, and then masking the surface layer excluding the through-hole and via-hole region, to forum thereby a via post by an electrofilling plating method. In this case, the height of the via post from the surface layer of the multilayer wiring board is made greater than the total thickness of the polymerization initiating layer and the specific polymer layer, and then the compositions that form the respective layers are applied and cured (by reaction). The resin at the top of the via post is removed by polishing the top part of the via post, and then a known method for forming a metal wiring is carried out. Thereby, connection between the electrical wiring at the surface layer and the via post may be obtained.

In addition to the processing method described above, a multilayer wiring board having interlayer conduction secured may also be obtained by carrying out a batch lamination method such that plating is performed on the specific polymer layer on a single layer base material, through-hole processing is carried out, a single-sided or both-sided wiring substrate having a conduction means provided inside the through-holes, and then batch laminating them all. In regard to the through-hole processing method according to this method, it is preferable to carry out the above-described method for each layer.

Furthermore, in regard to the build-up method, an interlayer conduction structure may be formed without performing via-hole processing. For example, a via post formed from a material capable of electrical conduction is first formed in a desired area on the metal wiring exposed at the outermost layer, and then an interlayer insulating film, and if necessary,

a polymerization initiating layer a specific polymer layer are laminated in this sequence. Subsequently, the surface is smoothened by abrasion, and thereby the top part of the via post is exposed. After such processes, an electrically connected structure may be formed between the lower layers and the upper layers by forming a metal thin film on the specific polymer layer.

## EXAMPLES

Hereinafter, the invention will be described in detail by way of examples, but the invention is not intended to be limited to these. Furthermore, unless particularly stated otherwise, "%" and "parts" are on a mass basis.

### [Example 1]

[Production of object to be plated]

(Production of base material)

First, a mixed solution prepared by mixing 11.9 parts by mass of jER806 (trade name, manufactured by Japan Epoxy Resins Co., Ltd.; bisphenol F type epoxy resin), 4.7 parts by mass of LA7052 (trade name, PHENOLITE, manufactured by Dainippon Ink and Chemicals, Inc.; curing agent), 21.7 parts by mass of YP50-35EK (trade name, manufactured by Tohto Kasei Co., Ltd..; phenoxy resin), 61.6 parts by mass of cyclohexanone, and 0.1 parts by mass of 2-ethyl-4-methylimidazole (curing accelerating agent), was filtered through a filter cloth (mesh size #200), and thus a coating liquid was prepared.
This coating liquid was applied on a glass epoxy substrate with a spin coater (rotation at 300 rpm for 5 seconds, and then rotation at 1500 rpm for 25 seconds), and then the coating liquid was cured by drying at 170°C. The thickness of the cured polymerization initiating layer was 1.3 μm.
Thereby, a base material having a polymerization initiating layer was obtained.

(Synthesis of polymer A having interactable group and polymerizable group)

A polymer A having an interactable group and a polymerizable group was synthesized as follows.
In a 1000-ml three-necked flask, 35 g of N,N-dimethylacetamide was placed and heated to 75°C under a nitrogen gas stream. A solution containing 6.60 g of 2-hydroxyethyl acrylate (a commercially available product, manufactured by Tokyo Chemical Industry Co., Ltd.), 28.4 g of 2-cyanoethyl acrylate, and 0.65 g of V-601 (trade name, manufactured by Wako Pure Chemical Industries, Ltd.) in 35 g of N,N-dimethylacetamide, was added dropwise thereto over 2.5 hours. After completion of the dropwise addition, the mixture was heated to 80°C and then was stirred for 3 hours. Subsequently, the reaction solution was cooled to room temperature.
To this reaction solution, 0.29 g of di-tertiary-butylhydroquinone, 0.29 g of dibutyltin dilaurate, 18.56 g of KARENZ AOI (trade name, Showa Denko K.K.), and 19 g of N,N-dimethylacetamide were added, and the mixture was allowed to react for 4 hours at 55°C. Subsequently, 3.6 g of methanol was added to the reaction liquid, and the resulting mixture was allowed to react for another 1.5 hours. After completion of the reaction, reprecipitation was carried out with ethyl acetate: hexane = 1: 1, and solids were taken out. Thus, 32 g of a polymer A having an interactable group and a polymerizable group (weight average molecular weight 62,000) was obtained.

(Formation of specific polymer layer)

10.5 parts by mass of the polymer A having an interactable group and a polymerizable group, 73.3 parts by mass of acetone, 33.9 parts by mass of methanol, and 4.8 parts by mass of N,N-dimethylacetamide were mixed under stirring, and thus a coating solution A was prepared.
The prepared coating solution A was applied on a base material having a polymerization initiating layer produced as described above, using a spin coater (rotation at 300 rpm for 5 seconds, and then rotation at 750 rpm for 20 seconds), and then the coating solution was dried at 80°C.
Subsequently, the resulting assembly was exposed by irradiation for 100 seconds using a UV exposure machine (product No.: UVF-502S, manufactured by San-Ei Electric Co., Ltd.; lamp: UXM-501MD) at an irradiation power of 10 $mW/cm^2$ (the irradiation power was measured using an ultraviolet integration actinometer (trade name: UIT150, manufactured by Ushio Denki Co., Ltd.) and a photoreceptive sensor (trade name: UVD-S254, manufactured by Ushio Denki Co., Ltd.).
Thereby, an object to be plated having a specific polymer layer was obtained.
Subsequently, the object to be plated having a specific polymer layer was immersed in acetonitrile for 5 minutes, while acetonitrile was being stirred. Then, the object to be plated was washed with distilled water.

At this time, the thickness of the formed specific polymer layer was 0.6 μm.

[Application of plating catalyst liquid]

0.5% by mass of palladium nitrate was dissolved in a mixed solution of water:acetone = 80:20 (mass ratio), and the undissolved matter was filtered through a filter paper. The object to be plated having a specific polymer layer was immersed in the resulting solution for 15 minutes.
Subsequently, the object to be plated having a specific polymer layer was immersed in a mixed solution of water:acetone = 80:20 (mass ratio) for 15 minutes, and was washed.

[Electroless plating]

THRU-CUP PGT (trade name, manufactured by C. Uyemura & Co., Ltd.) was used, and a bath under the bath constitution conditions as described in the following Table 1 was used as an electroless plating bath.
[Table 1]

| Order of liquid preparation | Bath constitution of 1 L electroless plating bath |
|---|---|
| 1. Distilled water | About 60 Vol.% |
| 2. PGT-A | 9.0 Vol.% |
| 3. PGT-B | 6.0 Vol.% |
| 4. PGT-C | 3.5 Vol.% |
| 5. Formalin liquid* | 2.3 Vol.% |
| 6. Distilled water | Liquid level adjusted to 1 L |

Formalin liquid: formaldehyde liquid (special grade) manufactured by Wako Pure Chemical Industries, Ltd.
The temperature of the electroless plating bath was adjusted to 26°C, and the pH was adjusted to 12.6 with sodium hydroxide and sulfuric acid. Electroless plating was performed using this bath.

(Evaluation of initial plating precipitation property)

The time of electroless plating taken to obtain a uniform copper electroless plating film having a thickness of 0.2 μm by the method described above, was measured. The time was 90 minutes.

[Electroplating]

Subsequently, electroplating was performed for 30 minutes under the conditions of 3 A/dm$^2$, using the copper electroless plating film as a power supply layer and a copper electroplating bath having the following composition. The thickness of the obtained copper electroplating film was 19.5 μm.

(Composition of electroplating bath)

- Copper sulfate 38 g
- Sulfuric acid 95 g
- Hydrochloric acid 1 mL
- COPPER GLEAM PCM (manufactured by Meltex, Inc.) 3 mL
- Water 500 g

(Evaluation of adhesiveness)

The plating film obtained as described above was subjected to a baking treatment for 30 minutes at 100°C and for 1 hour at 170°C. Subsequently, the 90° peel strength was measured for a piece of the plating film having a width of

5 mm at a tensile rate of 10 mm/min using AUTOGRAPH AGS-J (trade name, manufactured by Shimadzu Corp.). The 90° peel strength was 0.77 kN/m.

[Examples 2 to 4]

Plating films were formed in the same manner as in Example 1, except that the mixed solution in the plating catalyst liquid used in Example 1 was replaced with the following.

Example 2: Mixed solution of water:acetone = 90:10 (mass ratio)
Example 3: Mixed solution of water:acetone = 40:60 (mass ratio)
Example 4: Mixed solution of water:acetone = 20:80 (mass ratio)

(Evaluation of initial plating precipitation property)

The time for electroless plating taken to obtain a uniform copper electroless plating film having a thickness of 0.2 μm by the method described above, was measured, and the time was 120 minutes, 60 minutes and 30 minutes, respectively, for Examples 2, 3 and 4.

(Evaluation of adhesiveness)

An adhesiveness test was carried out for the obtained plating films in the same manner as in Example 1, and the measurement results for the 90° peel strength were as follows.

Example 2: 0.72. kN/m
Example 3: 0.71 kN/m
Example 4: 0.73 kN/m

As such, the adhesiveness of the plating films exhibited high values equally for Examples 1 to 4, but it was found that when a mixed solution containing a larger amount of acetone relative to water is used as the plating catalyst liquid, the rate of initial precipitation of electroless plating may be increased.

## Claims

**1.** A plating method comprising:

(a) applying a plating catalyst liquid containing a catalytic element and an organic solvent, to an object to be plated having, at least at a surface thereof, a functional group capable of forming an interaction with the catalytic element; and
(b) performing plating on the object to be plated, to which the plating catalyst liquid has been applied.

**2.** The plating method of claim 1, wherein the object to be plated has, at a surface of a base material, a polymer layer formed from a polymer which has a functional group capable of forming an interaction with the catalytic element and is directly chemically bonded to the base material.

**3.** The plating method of claim 2, wherein the polymer layer is formed by directly chemically bonding a polymer having a polymerizable group and a functional group capable of forming an interaction with the catalytic element, to the surface of the base material, and wherein the polymer is a copolymer containing a unit represented by the following formula (1) and a unit represented by the following formula (2):

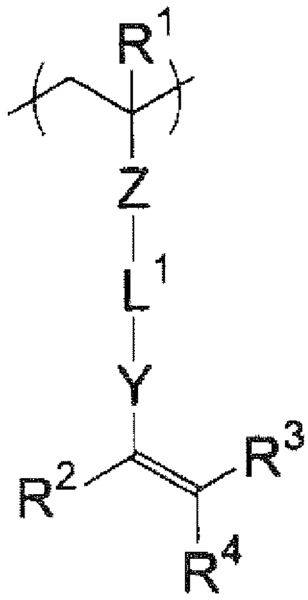

Formula (1)

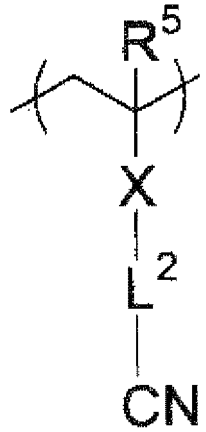

Formula (2)

wherein in formula (1) and formula (2), $R^1$ to $R^5$ each independently represent a hydrogen atom, a substituted alkyl group, or an unsubstituted alkyl group; X, Y and Z each independently represent a single bond, a substituted divalent organic group, an unsubstituted divalent organic group, an ester group, an amide group, or an ether group; and $L^1$ and $L^2$ each independently represent a substituted divalent organic group or an unsubstituted divalent organic group.

**4.** The plating method of claim 1, wherein electroless plating is performed in (b) the performing of the plating on the object to be plated, and a water-based electroless plating bath is used at the time of electroless plating.

**5.** The plating method of claim 1, wherein the organic solvent is a ketone-based solvent.

**6.** The plating method of claim 1, wherein the plating catalyst liquid further comprises water, and the content ratio of the water and the organic solvent is from 10:90 to 30:70 by mass.

**7.** The plating method of claim 1, wherein the catalytic element is Pd.

**8.** A method for forming a metal thin film using the plating method of claim 1.

**9.** A plating catalyst liquid comprising a catalytic element and an organic solvent, which is used for the plating method of claim 1.

## INTERNATIONAL SEARCH REPORT

International application No.
PCT/JP2008/073158

A. CLASSIFICATION OF SUBJECT MATTER
*C23C18/20*(2006.01)i, *C23C18/28*(2006.01)i

According to International Patent Classification (IPC) or to both national classification and IPC

B. FIELDS SEARCHED

Minimum documentation searched (classification system followed by classification symbols)
C23C18/20, C23C18/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 03/091476 A1 (Nikko Materials Co., Ltd.), 06 November, 2003 (06.11.03), Claims; page 2, line 15 to page 6, line 4 & US 2004/0235294 A1 & EP 1498511 A1 & TW 236070 B & CN 1623009 A | 1,4-5,7-9 |
| X | JP 2001-303254 A (Mitsuboshi Belting Ltd.), 31 October, 2001 (31.10.01), Claims; Par. Nos. [0015] to [0034] (Family: none) | 1,4,7-9 |
| Y<br>A | JP 2006-066180 A (Fuji Photo Film Co., Ltd.), 09 March, 2006 (09.03.06), Claims; Par. Nos. [0008] to [0026], [0061] to [0075] & WO 2006/019009 A1 & KR 10-2007-0055511 A | 1-2,4-9<br>3 |

☒ Further documents are listed in the continuation of Box C.    ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 February, 2009 (03.02.09) | 17 February, 2009 (17.02.09) |
| Name and mailing address of the ISA/ Japanese Patent Office | Authorized officer |
| Facsimile No. | Telephone No. |

Form PCT/ISA/210 (second sheet) (April 2007)

INTERNATIONAL SEARCH REPORT

International application No. PCT/JP2008/073158

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2001-181853 A (Nisshinbo Industries, Inc.), 03 July, 2001 (03.07.01), Claims; Par. Nos. [0028] to [0034] (Family: none) | 1-2,4-9<br>3 |
| Y<br>A | JP 61-227175 A (Director General, Agency of Industrial Science and Technology), 09 October, 1986 (09.10.86), Claims; page 2, lower right column, line 1 to page 4, upper left column, line 15 (Family: none) | 1-2,4-9<br>3 |
| Y<br>A | JP 2007-327131 A (Rohm and Hass Electronic Materials L.L.C.), 20 December, 2007 (20.12.07), Claims; Par. Nos. [0018] to [0021] & US 2008/0053834 A1 | 1-2,4-9<br>3 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 1315334 A
- JP 2001181853 A
- JP 63092658 A
- JP 10296895 A
- JP 11119413 A
- JP 2005281350 A
- JP 2007144820 A
- JP 2005307140 A
- JP 2007154306 A

### Non-patent literature cited in the description

- New Polymer Experimentology. Kyoritsu Shuppan Co., Ltd, 1994, vol. 10, 135